(19) Europäisches Patentamt / European Patent Office / Office européen des brevets

(11) **EP 2 800 154 A1**

(12) **EUROPEAN PATENT APPLICATION**
published in accordance with Art. 153(4) EPC

(43) Date of publication:
**05.11.2014 Bulletin 2014/45**

(51) Int Cl.:
*H01L 33/56* (2010.01)

(21) Application number: **12861320.5**

(22) Date of filing: **21.12.2012**

(86) International application number:
**PCT/JP2012/008216**

(87) International publication number:
**WO 2013/099193 (04.07.2013 Gazette 2013/27)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.12.2011 JP 2011283561**
**26.12.2011 JP 2011283566**
**29.02.2012 JP 2012043623**

(71) Applicant: **Konica Minolta, Inc.**
**Tokyo 100-7015 (JP)**

(72) Inventors:
• **YONEZAKI, Anumi**
**Tokyo 100-7015 (JP)**
• **MOCHIZUKI, Makoto**
**Tokyo 100-7015 (JP)**

(74) Representative: **Henkel, Breuer & Partner**
**Patentanwälte**
**Maximiliansplatz 21**
**80333 München (DE)**

(54) **SEALANT FOR LED DEVICE, LED DEVICE, AND METHOD FOR PRODUCING LED DEVICE**

(57) The objective of the present invention is to provide a sealant for an LED device capable of forming a sealing layer having a high level of light extraction, outstanding resistance to sulfidizing gas, and not giving rise to cracking or peeling even when used for extended periods, as well as an LED device employing the same. In order to attain at least one of the abovementioned objective, a sealant for an LED device reflecting one aspect of the present invention contains 100 mass parts of a 1000-3000 mass average molecular weight polysiloxane polymerized from a trifunctional monomethyl silane compound and a tetrafunctional silane compound, 5 mass parts to 100 mass parts of an organometallic compound comprising a metal alkoxide or metal chelate containing a Group 4 or Group 13 metal, and a solvent.

FIG. 1

EP 2 800 154 A1

**Description**

Technical Field

The present invention relates to a sealant for an LED device capable of sealing LED elements, an LED device, and a method for producing the LED device.

Background Art

In recent years, there has been widely used an LED device in which a phosphor such as a YAG phosphor is disposed around a gallium nitride (GaN)-based blue light-emitting diode (LED) chip, and blue light emitted from the blue LED chip is mixed with yellow light emitted from the phosphor that has received the blue light, so that white light is obtained. Also, there has been developed an LED device in which various phosphors are disposed around a blue LED chip, and blue light emitted from the blue LED chip is mixed with red light and green light emitted from the phosphors that have received the blue light, so that white light is obtained.

White LED devices have various applications and have been in demand as alternatives to fluorescent lamps and incandescent lamps. Such lighting devices are configured as a combination of multiple white LED devices, and how outcoupling efficiency can be increased for each white LED device is important for cost reduction and longer life.

For such a white LED device, techniques have been generally used in which the LED chip or mounting part of the LED chip is sealed with a transparent resin layer (wavelength conversion layer) in which phosphors are dispersed (see, e.g., PTL1). However, in the white LED device configured as such, the LED chip and encapsulation resin are greatly different in refractive index. Therefore, when light emitted from the LED chip is incident to the transparent resin layer, interfacial reflection easily occurs, resulting in remarkable reduction in outcoupling efficiency (external quantum efficiency).

Therefore, in PTL 2, irregularity is provided on a surface of the transparent resin layer in order to improve outcoupling efficiency. With this technology, a light generated inside the LED chip is scattered, dispersed and diffracted, so that outcoupling efficiency is increased. However, reflection occurs at an interface between the LED chip and the transparent resin layer, making it difficult to obtain sufficient outcoupling efficiency.

Further, the transparent resin layers disclosed in PTL 1 and PTL 2 have high gas permeability. Therefore, as time passes, a metallic reflector on which the LED chip is mounted is eroded, and, thus, reflection efficiency is reduced and outcoupling efficiency from the LED device is also reduced.

Silicone resins have excellent heat resistance and ultraviolet light resistance. In particular, phenyl silicone resins have low gas permeability as compared with methyl silicon resins and the like. Therefore, coating the LED chip with a phenyl silicone resin has been considered. However, the phenyl silicone resin does not yet have a sufficient sulfide gas resistance, and, thus, it has not been applied to exterior lighting devices that require high sulfide gas resistance. Further, the phenyl silicone resin does not have sufficient adhesion, transparency, and light resistance.

LED devices have also been suggested in which an LED chip and a metallic reflector are coated with an inorganic material layer and a transparent resin layer is stacked on the inorganic material layer (PTL 3). In this LED device, the metallic reflector is coated with the inorganic material layer having low gas permeability, and, thus, the metallic reflector is not easily eroded. In this LED device, refractive index decreases in order of light source, inorganic material layer, transparent resin layer, and atmosphere, and therefore reflection at interfaces between the layers decreases.

PTL 4 and PTL 5 disclose a technique of coating an LED chip and the like with tetrafunctional alkoxysilane. PTL 6 to PTL 8 disclose a technique of forming a sealing material containing siloxane by a sol-gel method. Further, PTL 9 and PTL 10 disclose a technique of forming a sealing material made of polymethyloxane by a sol-gel reaction of a metal alkoxide.

Citation List

Patent Literature

PTL 1 Japanese Patent Application Laid-Open No. 2002-314142
PTL 2 Japanese Patent Application Laid-Open No. 2011-166148
PTL 3 Japanese Patent Application Laid-Open No. 2007-324256
PTL 4 Japanese Patent No. 3275308
PTL 5 Japanese Patent Application Laid-Open No. 2003-197976
PTL 6 Japanese Patent Application Laid-Open No. 2004-231947

PTL 7 Japanese Patent Application Laid-Open No. 2002-33517
PTL 8 Japanese Patent Application Laid-Open No. 2002-203989
PTL 9 Japanese Patent Application Laid-Open No. 2002-76445
PTL 10 Japanese Patent Application Laid-Open No. 2010-182970

Summary of Invention

Technical Problem

However, according to the technique described in PTL 3, adhesion between the inorganic material layer and the transparent resin layer is not sufficient; and when a load is applied due to changes in temperature, the inorganic material layer and the transparent resin layer undesirably peel off. This occurs because the inorganic material layer and the transparent resin layer are different in linear expansion coefficient. Further, in the LED device described in PTL 3, gas barrier property is not sufficient, and, thus, as time passes, outcoupling efficiency is reduced. It is assumed that since the inorganic material layer is formed of sol-gel glass, the inorganic material layer is likely to be cracked, and, thus, as time passes, a gas barrier property is reduced.

Further, the sealing materials described in PTL 4 and PTL 5 are hydrolysates of tetrafunctional alkoxysilane; and typically become incomplete glass bodies containing 10 wt% or more of silanol. Therefore, the sealing materials do not have sufficient sulfide gas resistance. Also, tetrafunctional alkoxysilane contains a large amount of components to be separated during dehydration/dealcoholization condensation and essentially, it is greatly contracted during curing. Further, a polysiloxane formed of the tetrafunctional alkoxysilane is cured from its surface, and, thus, after hard gel is formed, an internal solvent is discharged to the outside and the polysiloxane is greatly contracted. As a result, it is difficult to obtain a sufficient sulfide gas resistance.

According to the technologies described in PTL 6 and PTL 8, a phosphor material functions as an aggregate of a layer. Therefore, if a phosphor is not added, it is not possible to obtain a glass-like sealing material which is transparent and does not have any cracks. Also, according to the technology described in PTL 7, an inorganic light scattering agent is contained in a sealing material. Also in this case, if an inorganic light scattering agent is not contained, it is difficult to obtain a glass-like sealing material which is transparent and does not have any cracks.

According to PTL 9 or PTL 10, a sealing material made of polymethyloxane is obtained by a sol-gel reaction of a silane alkoxide monomer or a mixture of a silane alkoxide with a titanium alkoxide or a zirconia alkoxide as a metal alkoxide. However, a solution formed of the alkoxide has poor storage stability, and due to the height of reactivity thereof, cracks easily occur during film formation.

Molten glass has also been considered as a material of sealing material. However, the molten glass is treated at a high treatment temperature of 350°C or higher and may damage an LED element, and, thus, it is not practical.

In view of the foregoing problems, the present invention has been achieved. That is, an object of the present invention is to provide a sealant for an LED device capable of forming a layer which has an excellent sulfide gas resistance and in which cracking or peeling-off does not occur in spite of long-term use, and an LED device using the same. Another object of the present invention is to provide an LED device including a light transmissive layer in which peeling-off does not occur even when a load is caused by a temperature.

Solution to Problem

In order to achieve the above-described objects, the inventors made intensive studies and established that by using a sealant for LED device composed of: a specific polysiloxane formed by polymerization of a trifunctional monomethylsilane compound and a tetrafunctional silane compound; an organic metal compound containing a Group 4 or Group 13 metal element; and a solvent, a cured film had high sulfide gas resistance and was not easily cracked.

Further, it was established that when a light transmissive layer formed of a cured film made of a composition for light transmissive layer containing a polysiloxane, metal oxide fine particles, and an organic solvent was embedded between an LED element and a wavelength conversion layer, adhesion between the light transmissive layer and the wavelength conversion layer was increased and the light transmissive layer was not easily cracked, and, thus, a gas barrier property of an LED device was improved over a long period of time. Furthermore, it was also found that since the light transmissive layer was embedded, outcoupling efficiency from the LED device was increased.

Also, it was found that when a primer layer was formed by applying an organic metal monomer on the LED element and the light transmissive layer was formed thereon, the LED element and the light transmissive layer were strongly and firmly stacked via the primer layer and heat resistance or gas barrier property of the LED device was increased.

That is, the present invention provides sealants for an LED device given below.

[1] A sealant for an LED device containing: 100 parts by weight of polysiloxane having a weight-average molecular weight of 1000 to 3000 and formed by polymerization of a trifunctional monomethylsilane compound and a tetrafunctional silane compound; 5 to 100 parts by weight of an organic metal compound formed of a metal alkoxide or a metal chelate containing a Group 4 or Group 13 metal element; and a solvent.

[2] The sealant for an LED device according to [1], in which the polysiloxane is a polymer formed by polymerization of the trifunctional monomethylsilane compound and the tetrafunctional silane compound at a molar ratio of 3:7 to 7:3.

[3] The sealant for an LED device according to [1] or [2], in which the organic metal compound contains Zr.

[4] The sealant for an LED device according to any one of [1] to [3], in which water is contained as the solvent, and the amount of the water added is 10 to 120 parts by weight with respect to 100 parts by weight of the polysiloxane.

[5] The sealant for an LED device according to any one of [1] to [4], further containing inorganic fine particles.

[6] The sealant for an LED device according to any one of [1] to [5], in which a pH is in a range of 1 to 4.

[7] The sealant for an LED device according to any one of [1] to [6], further containing phosphor particles.

The present invention provides the first LED devices and methods for producing the same given below.

[8] An LED device including: an LED element that emits a light having a specific wavelength; and a sealing layer formed of a cured film of the sealant for an LED device according to any one of [1] to [7].

[9] The LED device according to [8], further including: a wavelength conversion layer that contains a resin and phosphor particles and converts a light having a specific wavelength emitted from the LED element to a light having another specific wavelength, on the sealing layer.

[10] A method for producing an LED device including: applying the sealant for an LED device according to any one of [1] to [7] on an LED element; and forming a sealing layer by curing the sealant at 100°C or higher.

The present invention provides second LED devices given below.

[11] An LED device including: an LED element that emits a light having a specific wavelength; a light transmissive layer that coats the LED element; and a wavelength conversion layer that is disposed to be in contact with the light transmissive layer and configured to convert the light having a specific wavelength from the LED element into a light having another specific wavelength, and the light transmissive layer is formed of a cured film made of a composition for light transmissive layer containing polysiloxane formed by polymerization of monomers including a tetrafunctional silane compound, metal oxide fine particles, and a solvent.

[12] The LED device according to [11], in which the metal oxide fine particles are oxides of one or two or more metal elements selected from the group consisting of zirconium, titanium, tin, cerium, tantalum, niobium, and zinc.

[13] The LED device according to [11] or [12], in which the metal oxide fine particles has the concentration of 10 wt% to 60 wt% with respect to the solid content of the composition for light transmissive layer.

[14] The LED device according to any one of [11] to [13], in which the metal oxide fine particles have an average primary particle size of 5 nm to 100 nm.

[15] The LED device according to any one of [11] to [14], in which the polysiloxane is a polymer of monomers including a trifunctional monomethylsilane compound and a tetrafunctional silane compound and the trifunctional monomethylsilane compound and the tetrafunctional silane compound are polymerized at a molar ratio of 3:7 to 7:3.

[16] The LED device according to any one of [11] to [15], in which the composition for light transmissive layer contains an organic metal compound formed of a metal alkoxide or a metal chelate containing a metal element except element Si.

[17] The LED device according to any one of [11] to [16], in which the composition for light transmissive layer includes water as the solvent, and the amount of the water added is 3 wt% to 15 wt% with respect to the total amount of the composition for light transmissive layer.

[18] The LED device according to any one of [11] to [17], in which the light transmissive layer has a thickness of 0.5 to 10 $\mu$m.

The present invention provides methods for producing the second LED device given below.

[19] A method for producing an LED device including an LED element that emits a light having a specific wavelength, a light transmissive layer that coats the LED element, and a wavelength conversion layer that is disposed to be in contact with the light transmissive layer and configured to convert the light having a specific wavelength from the LED element into a light having another specific wavelength, the method including: forming a light transmissive layer by applying and curing a composition for light transmissive layer containing polysiloxane formed by polymerization of monomers including a tetrafunctional silane compound, metal oxide fine particles, and a solvent.

The present invention provides third LED devices given below.

[20] An LED device including: an LED element that emits a light having a specific wavelength; a primer layer that coats the LED element; a light transmissive layer that is disposed to be in contact with the primer layer; and a wavelength conversion layer that is disposed on the light transmissive layer and configured to convert the light having a specific wavelength from the LED element into a light having another specific wavelength, and the primer layer is formed by applying and drying a composition for primer layer containing an organic metal monomer having a reactive functional group and a solvent on the LED element and the light transmissive layer is formed by applying and calcining a composition for light transmissive layer containing polysiloxane formed by polymerization of monomers including a tetrafunctional silane compound and a solvent on the primer layer.

[21] The LED device according to [20], in which the organic metal monomer is a monomer including any one or two or more metal elements of silicon, titanium, or zirconium.

[22] The LED device according to [20] or [21], in which the number of the reactive functional groups in the organic metal monomer is 3 or 4.

[23] The LED device according to any one of [20] to [22], in which a surface of the primer layer contains 10 at.% to 35 at.% of a metal element derived from the organic metal monomer with respect to all elements present in the surface.

[24] The LED device according to any one of [20] to [23], in which the polysiloxane is a polymer of monomers including a trifunctional monomethylsilane compound and a tetrafunctional silane compound and the trifunctional monomethylsilane compound and the tetrafunctional silane compound are polymerized at a molar ratio of 3:7 to 7:3.

[25] The LED device according to any one of paragraphs [20] to [24], in which the composition for light transmissive layer includes water as the solvent, and the amount of the water added is 3 to 15 wt% with respect to the total amount of the composition for light transmissive layer.

[26] The LED device according to any one of [20] to [25], in which the composition for light transmissive layer contains metal oxide fine particles.

[27] The LED device according to any one of [20] to [26], in which the light transmissive layer has a thickness of 0.5 to 10 $\mu$m.

[28] The LED device according to any one of [20] to [27], in which the wavelength conversion layer is a layer in which phosphor particles are dispersed in a transparent resin.

The present invention provides methods for producing the third LED device given below.

[29] A method for producing an LED device including an LED element that emits a light having a specific wavelength, a primer layer that coats the LED element, a light transmissive layer that is disposed to be in contact with the primer layer, and a wavelength conversion layer that is disposed on the light transmissive layer and configured to convert the light having a specific wavelength from the LED element into a light having another specific wavelength, the method including: forming the primer layer by applying and drying a composition for primer layer containing an organic metal monomer having a reactive functional group and a solvent on the LED element; and forming the light transmissive layer by applying and calcining a composition for light transmissive layer containing polysiloxane formed by polymerization of monomers including a tetrafunctional silane compound and a solvent on the primer layer.

Advantageous Effects of Invention

The cured film of the sealant for an LED device of the present invention has excellent adhesion with respect to the LED element (for example, a metallic reflector or a package) and also has a high sulfide gas resistance. Further, the sealant for an LED device of the present invention is not much contracted during curing, and, thus, the cured film is not easily cracked. Therefore, the first LED device including the cured film of the sealant has high sulfide gas resistance as well as excellent adhesion and outcoupling efficiency.

The light transmissive layer of the second LED device of the present invention has very high adhesion to the wavelength conversion layer and also has excellent light transmissivity. Further, the light transmissive layer is not easily cracked, and, thus, a gas barrier property is less likely to decrease as time passes. Therefore, the LED device of the present invention has a high sulfide gas resistance over a long period of time.

In the third LED device of the present invention, a metal in the primer layer forms a strong and firm metal-oxane bonding with a hydroxyl group present in a metal part of the LED element or a surface of the package, or a polysiloxane compound in the light transmissive layer. Therefore, in the LED device of the present invention, even when a load is applied due to changes in temperature, layer separation and the like dos not occur and heat resistance and gas barrier property are high.

Brief Description of Drawings

FIG. 1 is a schematic cross-sectional view illustrating a configuration example of a first LED device according to the present invention;

FIG. 2 is a schematic cross-sectional view illustrating another configuration example of the first LED device according to the present invention;

FIG. 3 is a schematic cross-sectional view illustrating a configuration example of the first LED device according to the present invention;

FIG. 4 is a schematic cross-sectional view illustrating a configuration example of a second LED device according to the present invention;

FIG. 5 is a schematic cross-sectional view illustrating another configuration example of the second LED device according to the present invention;

FIG. 6 is a schematic cross-sectional view illustrating a configuration example of a third LED device according to the present invention; and

FIG. 7 is a schematic cross-sectional view illustrating another configuration example of the third LED device according to the present invention.

Description of Embodiments

While the invention will be specifically described below, it is not intended to limit the present invention to a preferred embodiment but the present invention may be further modified within the scope of the gist.

1. Sealant for LED device

A sealant for an LED device according to the present invention is used for forming a layer that seals an LED element. A cured film (sealing layer) of the sealant for an LED device of the present invention has excellent adhesion to the LED element and also has high sulfide gas resistance. Further, even when the cured film is formed into a thick film, it has excellent transparency, light resistance, and heat resistance and it is not likely to be cracked in spite of long-term use. Furthermore, when the cured film is included in an LED device, outcoupling efficiency of the LED device is increased.

The following describes a possible mechanism by which such properties can be obtained. In general, a film formed of polysiloxane only cannot be sufficiently bonded to a metal part of the LED element (metallic electrode reflector) or hydroxyl groups present present on the surface of the resin package and thus has low adhesion to these members. On the other hand, the sealant for an LED device of the present invention contains a metal (organic metal compound) having a higher reactivity and more reaction points than Si. Therefore, firm metal-oxane bonds are formed between the metal and the polysiloxane or the hydroxyl groups of each member of the LED element. This is considered to provide excellent adhesion so that an excellent sulfide gas resistance can be expressed.

The organic metal compound contained in the sealant for an LED device of the present invention forms a nanoscale cluster in the cured film. It is considered that since this cluster oxidizes a hydrogen sulfide gas which is highly corrosive to metal and converts the gas into a sulfur dioxide gas which is less corrosive to metal by photocatalytic activity, excellent sulfide gas resistance can be obtained.

Furthermore, the sealant for an LED device of the present invention contains a polysiloxane formed by polymerization of a trifunctional monomethylsilane compound and a tetrafunctional silane compound and having a relatively high degree of cross-linking. Therefore, the sealant has an excellent light resistance or heat resistance and also has an excellent outcoupling property. On the other hand, it is considered that since methyl group derived from trifunctional monomethylsilane remains within the polysiloxane, flexibility can be somewhat applied to the polysiloxane, and, thus, crack resistance of the cured film can be improved.

The sealant for an LED device of the present invention is largely classified into 1) an aspect where phosphor particles are not contained (referred to as "binder-type sealant") and 2) an aspect where phosphor-containing particles are contained (referred to as "phosphor-containing sealant").

(1) Binder-type sealant

A binder-type sealant contains a polysiloxane, an organic metal compound, and a solvent, and may further contain inorganic fine particles and the like as necessary.

(1-1) Polysiloxane

The polysiloxane contained in the binder-type sealant is a polymer of a trifunctional monomethylsilane compound and a tetrafunctional silane compound.

The trifunctional monomethylsilane compound includes a compound expressed by the following general formula (I):

$$CH_3Si(OR^1)_3 \qquad (I).$$

where each $R^1$ independently represents an alkyl group or a phenyl group, and preferably represents an alkyl group having 1 to 5 carbon atoms or phenyl group

To be specific, examples of the trifunctional monomethylsilane compound include: methyltrimethoxysilane, methyltriethoxysilane, methyltripropoxysilane, methyltripentyloxysilane, methylmonomethoxydiethoxysilane, methylmonomethoxydipropoxysilane, methylmonomethoxydipentyloxysilane, methylmonomethoxydiphenyloxysilane, methylmethoxyethoxypropoxysilane, and methylmonomethoxymonoethoxymonobutoxysilane. Among them, methyltrimethoxysilane and methyltriethoxysilane are preferable, and methyltrimethoxysilane is more preferable.

An example of the tetrafunctional methyl silane compound includes a compound expressed by the following general formula (II).

$$Si(OR^2)_4 \qquad (II)$$

In general formula (II) above, each $R^2$ independently represents an alkyl group or a phenyl group, and preferably represents an alkyl group having 1 to 5 carbon atoms or phenyl group.

Examples of the tetrafunctional silane compound include: tetraalkoxysilanes such as tetramethoxysilane, tetraethoxysilane, tetrapropoxysilane, tetrabutoxysilane, tetrapentyloxysilane, tetraphenyoxysilane, trimethoxymonoethoxysilane, dimethoxydiethoxysilane, triethoxymonomethoxysilane, trimethoxymonopropoxysilane, monomethoxytributoxysilane, monomethoxytripentyloxysilane, monomethoxytriphenyloxysilane, dimethoxydipropoxysilane, tripropoxymonomethoxysilane, trimethoxymonobutoxysilane, dimethoxydibutoxysilane, triethoxymonopropoxysilane, diethoxydipropoxysilane, tributoxymonopropoxysilane, dimethoxymonoethoxymonobutoxysilane, diethoxymonomethoxymonobutoxysilane, diethoxymonopropoxymonobutoxysilane, dipropoxymonomethoxymonoethoxysilane, dipropoxymonomethoxymonobutoxysilane, dipropoxymonoethoxymonobutoxysilane, dibutoxymonomethoxymonoethoxysilane, dibutoxymonoethoxymonopropoxysilane, and monomethoxymonoethoxymonopropoxymonobutoxysilane. Among them, tetramethoxysilane and tetraethoxysilane are preferable.

The polysiloxane is not specifically limited in a polymerization ratio as long as it is a polymer of the trifunctional monomethylsilane compound and the tetrafunctional silane compound. In particular, polysiloxane polymerized at a molar ratio of 3:7 to 7:3 is preferable, and polysiloxane polymerized at a molar ratio of 4:6 to 6:4 is more preferable. If the molar ratio of the tetrafunctional silane compound is excessive, the degree of cross-linking of the polysiloxane increases while the cured film is formed. Therefore, the cured film is greatly contracted and thus is likely to be cracked. Further, if the molar ratio of the trifunctional monomethylsilane compound is excessive, the amount of methyl group (organic group) derived from trifunctional monomethylsilane in the cured film is increased. Thus, during application of the binder-type sealant, repelling of liquid may easily occur. Further, since the degree of cross-linking of the polysiloxane is reduced, sulfide gas resistance is likely to decrease.

The weight-average molecular weight of the polysiloxane is 1,000 to 3,000, preferably 1,200 to 2,700, and more preferably 1,500 to 2,000. When the weight-average molecular weight of the polysiloxane is less than 1,000, the viscosity is low and repelling of liquid may easily occur. On the other hand, when the weight-average molecular weight is more than 3000, the viscosity is increased and it may be difficult to form a uniform film. Further, embedability of the LED element may be reduced. The weight-average molecular weight is a value measured by gel permeation chromatography (in terms of polystyrene).

Method of preparing polysiloxane

The polysiloxane is prepared by hydrolyzing and condensing the trifunctional monomethylsilane compound and the tetrafunctional silane compound under the presence of an acid catalyst, water, and an organic solvent. The weight-average molecular weight of the obtained polysiloxane is adjusted by reaction conditions (particularly, a reaction time) or the like.

The trifunctional monomethylsilane compound and the tetrafunctional silane compound may be mixed in advance at the above-described molar ratio for random polymerization. Alternatively, block polymerization may be carried out wherein after only the trifunctional monomethylsilane compound is polymerized to some extent, only the tetrafunctional silane compound is further polymerized to the polymer.

The acid catalyst which is added during polymerization of the trifunctional monomethylsilane compound and the tetrafunctional silane compound may be any one of organic acids or inorganic acids as long as it is a compound for hydrolyzing a silane compound under the presence of water.

Examples of the inorganic acids may include sulfuric acid, phosphoric acid, nitric acid, and hydrochloric acid. Among them, phosphoric acid and nitric acid are preferable. Also, examples of the organic acids may include compounds containing carboxylic acid residues such as formic acid, oxalic acid, fumaric acid, maleic acid, glacial acetic acid, acetic anhydride, propionic acid, and n-butyric acid, and sulfur-containing acid residues such as organic sulfonic acids. Examples of the organic acids may include organic sulfonic acids or their esterified compounds (organic sulfuric acid esters and organic sulfurous esters).

Preferably, the acid catalyst is an organic sulfonic acid expressed by the following general formula (III):

$$R^3\text{-}SO_3H \qquad (III)$$

where $R^3$ represents a hydrocarbon group which may have a substituent

In general formula (III) above, the hydrocarbon group represented by $R^3$ may include linear, branched, and cyclic hydrocarbon groups having 1 to 20 carbon atoms. The hydrocarbon may be saturated hydrocarbon or may be unsaturated hydrocarbon. Further, the hydrocarbon may have a substituent such as a halogen atom, for example, a fluorine atom; a sulfonic acid group; a carboxylic acid group; a hydroxyl group; an amino group; and a cyano group.

In general formula (III) above, examples of a cyclic hydrocarbon group represented by $R^3$ may include an aromatic hydrocarbon group such as a phenyl group, a naphthyl group, and an anthryl group. In particular, a phenyl group is preferable. The aromatic hydrocarbon group may have a linear, branched, or cyclic saturated or unsaturated hydrocarbon group having 1 to 20 carbon atoms in a substituent.

Preferably, the organic sulfonic acid expressed by general formula (III) above is nonafluorobutane sulfonic acid, methane sulfonic acid, trifluoromethane sulfonic acid, dodecyl benzene sulfonic acid, or a mixture thereof.

The amount of the acid catalyst mixed during preparation of the polysiloxane is preferably in a range of 1 to 1,000 ppm as the concentration of the acid catalyst in a system for hydrolyzing a silane compound, and more preferably in a range of 5 to 800 ppm.

Further, a film quality or a storage stability of the polysiloxane varies depending on the amount of water mixed during preparation of the polysiloxane. Therefore, a water addition ratio is appropriately adjusted depending on a targeted film quality or the like. Herein, the term "water addition ratio" means a ratio (%) of a molar amount of added water molecules to a molar amount of an alkoxy group of the silane compound added to a reaction system for preparing the polysiloxane.

The water addition ratio is preferably 50 to 200% and more preferably 75 to 180%. When the water addition ratio is 50% or more, the film quality of the cured film of the binder-type sealant becomes stable. Further, when the water addition ratio is 200% or less, the storage stability of the binder-type sealant improves.

Examples of the solvent used during preparation of the polysiloxane may include monohydric alcohols such as methanol, ethanol, propanol, and n-butanol; alkylcarboxylic esters such as methyl-3-methoxypropionate and ethyl-3-ethoxypropionate; polyols such as ethylene glycol, diethylene glycol, propylene glycol, glycerin, trimethylol propane, and hexane triol; monoethers of polyols such as ethylene glycol monomethyl ether, ethylene glycol monoethyl ether, ethylene glycol monopropyl ether, ethylene glycol monobutyl ether, diethylene glycol monomethyl ether, diethylene glycol monoethyl ether, diethylene glycol monopropyl ether, diethylene glycol monobutyl ether, propylene glycol monomethyl ether, propylene glycol monoethyl ether, propylene glycol monopropyl ether, and propylene glycol monobutyl ether, or monoacetates thereof; esters such as acetic acid methyl, acetic acid ethyl, and acetic acid butyl; ketones such as acetone, methylethylketone, and methylisoamylketone; and polyol ethers alkyletherified from all hydroxylic groups of polyols such as ethylene glycol dimethyl ether, ethylene glycol diethyl ether, ethylene glycol dipropyl ether, ethylene glycol dibutyl ether, propylene glycol dimethyl ether, propylene glycol diethyl ether, diethylene glycol dimethyl ether, diethylene glycol diethyl ether, and diethylene glycol methylethyl ether. One of these solvents may be used alone, or two or more of these solvents may be combined.

(1-2) Organic metal compound

The binder-type sealant contains an organic metal compound formed of a metal alkoxide or metal chelate containing a Group 4 or Group 13 metal element. As described above, a metal in the organic metal compound forms a metal-oxane bonding with polysiloxane or a hydroxyl group present in a surface of each member of the LED element. Further, a part of the organic metal compound forms a nanoscale cluster formed by siloxane bonding in the cured film of the binder-type sealant.

Preferably, the organic metal compound is a compound expressed by the following general formula (IV):

$$M^m + X_n Y_{m-n} \ldots (IV)$$

where M represents a metal element of Group 4 or Group 13. Further, in general formula (IV), m represents a valence of M and represents 3 or 4. In general formula (IV), n represents the number of X groups and is an integer of 2 or more to 4 or less. Herein, m is equal to or greater than n.

In general formula (IV), preferably, the metal element represented by M is aluminum, zirconium, and titanium, and particularly preferably zirconium. A metal alkoxide or metal chelate of zirconium does not have an absorption wavelength in an emission wavelength region (particularly, blue light (wavelength: 420 nm to 485 nm)) of a general LED element. Therefore, a cured film containing a zirconium-based metal element does not absorb but transmits a light emitted from an LED element. As a result, the outcoupling property of an LED device can be improved.

In general formula (IV), X represents a reactive functional group. The term "reactive functional group" means a group that is hydrolyzed with water in the binder-type sealant and generates a sufficiently reactive hydroxyl group. Examples of the reactive functional group may include lower alkoxy groups having 1 to 5 carbon atoms, acetoxy group, butane oxime group, and chloro group. These reactive functional groups may be present singly or in combination of two or more types. The reactive functional group is preferably a lower alkoxy group having 1 to 5 carbon atoms, and more preferably methoxy group or ethoxy group considering that a component to be separated after reaction is neutral. Since these reactive functional groups are sufficiently reactive and a solvent to be separated boils fast, it is possible to remove them easily. Further, in general formula (IV), when X is acetoxy group or chloro group, acetic acid or hydrochloric acid is liberated by hydrolysis reaction. In this case, acid components may be removed after reaction.

Also, in general formula (IV), Y represents a monovalent organic group. Example of the monovalent organic group represented by Y may include a publicly-known group as a monovalent organic group of a so-called silane coupling agent. To be specific, Y represents an aliphatic group, an alicyclic group, an aromatic group, and an alicyclic aromatic group having 1 to 1,000 carbon atoms, preferably, 500 or less carbon atoms, more preferably 100 or less carbon atoms, still more preferably 50 or less carbon atoms, and particularly preferably 6 or less carbon atoms. They may have an atom such as O, N, or S, or an atom group as a linking group. Among them, in particular, the monovalent organic group represented by Y is preferably a methyl group considering that light resistance and heat resistance of the cured film of the binder-type sealant can be improved.

In general formula (IV), the organic group represented by Y may have a substituent. Examples of the substituent may include: atoms such as F, Cl, Br, and I; and organic functional groups such as vinyl group, methacryloxy group, acryloxy group, styryl group, mercapto group, epoxy group, epoxy cyclohexyl group, glycidoxy group, amino group, cyano group, nitro group, sulfonic acid group, carboxyl group, hydroxyl group, acyl group, alkoxy group, imino group, and phenyl group.

A specific example of the organic metal compound expressed by general formula (IV) includes the compounds described below. Examples of metal alkoxide or metal chelate containing aluminum may include aluminum triisopropoxide, aluminum tri-n-butoxide, aluminum tri-t-butoxide, and aluminum triethoxide.

Examples of metal alkoxide or metal chelate containing zirconium may include zirconium tetramethoxide, zirconium tetraethoxide, zirconium tetra-n-propoxide, zirconium tetra-i-propoxide, zirconium tetra-n-butoxide, zirconium tetra-i-butoxide, zirconium tetra-t-butoxide, zirconium dimethacrylate dibutoxide, and dibutoxy zirconium bis(ethyl acetoacetate).

Examples of metal alkoxide or metal chelate containing titanium may include titanium tetraisopropoxide, titanium tetra-n-butoxide, titanium tetra-i-butoxide, titanium methacrylate triisopropoxide, titanium tetramethoxy propoxide, titanium tetra-n-propoxide, titanium tetraethoxide, titanium lactate, titanium bis(ethyl hexoxy)bis (2-ethyl-3-hydroxy hexoxide), and titanium acetyl acetonate.

Herein, the compounds described above as examples are some of readily available commercial organic metal compounds, and the compounds listed in a table regarding coupling agents and relevant products in Chapter 9 of "Technology of Optimal Use of Coupling Agent" published by National Institute of Advanced Science and Technology can be applied to the present invention as the organic metal compound.

In the binder-type sealant, the organic metal compound is contained in the amount of preferably 5 to 100 parts by weight, more preferably 8 to 40 parts by weight, and still more preferably 10 to 15 parts by weight, with respect to 100 parts by weight of the polysiloxane. If the amount of the organic metal compound is less than 5 parts by weight, an effect of organic metal compound addition cannot be obtained. On the other hand, if the amount is more than 100 parts by weight, the storage stability of the binder-type sealant is reduced.

(1-3) Solvent

The binder-type sealant contains a solvent. The solvent may be an aqueous solvent such as a combination of water and an organic solvent highly compatible with water; or a water-free, non-aqueous solvent which is an organic solvent less compatible with water. Examples of the organic solvent highly compatible with water may include alcohols such as methanol, ethanol, propanol, and butanol.

Preferably, the binder-type sealant of the present invention contains, particularly, an aqueous solvent, that is, water. The amount of water contained in the binder-type sealant is preferably 10 to 120 parts by weight and more preferably 80 to 100 parts by weight with respect to 100 parts by weight of the polysiloxane. If water is contained in the amount of 10 or more parts by weight with respect to 100 parts by weight of the polysiloxane, it is possible to sufficiently hydrolyze the polysiloxane and a moist-heat resistance of the cured film is increased. On the other hand, if water is contained in the amount of 120 or more parts by weight with respect to 100 parts by weight of the polysiloxane, hydrolysis may occur while the binder-type sealant is stored and preserved.

Preferably, the solvent of the binder-type sealant may include an organic solvent having a boiling point of 150°C or higher, such as ethylene glycol and propylene glycol. When the binder-type sealant contains an organic solvent having a boiling point of 150°C or higher, the storage stability of the binder-type sealant can be improved. Further, if the binder-type sealant contains an organic solvent having a boiling point of 150°C or higher, the binder-type sealant is stable even within an applicator. On the other hand, when the solvent has a boiling point of 250°C or lower, the drying property of the binder-type sealant is increased.

(1-4) Inorganic fine particles

The binder-type sealant may contain inorganic fine particles. When the binder-type sealant contains inorganic fine particles, the viscosity of the binder-type sealant is increased and the strength of the cured film is improved. Further, when the binder-type sealant contains inorganic fine particles having a high refractive index, outcoupling efficiency of the cured film of the binder-type sealant is increased.

Examples of the inorganic fine particles may include oxide particles of zirconium oxide, silicon oxide, titanium oxide, zinc oxide, and the like, and fluoride particles of magnesium fluoride and the like.

Preferably, the average particle size of the inorganic fine particles is in a range of 1 nm to 50 $\mu$m. The average particle size of the inorganic fine particles can be measured, for example, by the Coulter counter method. When the average particle size is in the above-described range, the viscosity of the binder-type sealant is likely to be increased and the strength of the cured film is also likely to be increased.

Preferably, the inorganic fine particles are porous particles and have a specific surface area of 200 m$^2$/g or more. If the inorganic fine particles are porous particles, the solvent seeps into voids of the porous particles, and, thus, the viscosity of the binder-type sealant can be effectively increased. However, the viscosity of the binder-type sealant is not determined just by the amount of the porous inorganic fine particles, but varies depending on a ratio between the inorganic fine particles and the solvent or amounts of the other components.

The amount of the inorganic fine particles in the binder-type sealant may be determined such that the amount of the inorganic fine particles in a cured product of the binder-type sealant is in a range of preferably 0.5 wt% or more to 50 wt% or less and more preferably 1 to 40 wt%. If the amount of the inorganic fine particles is less than 0.5 wt%, the above-described effect of viscosity increase or the effect of strength improvement of the cured film cannot be obtained. On the other hand, if the amount is more than 50 wt%, the strength of the cured film of the binder-type sealant may decrease.

The surface of the inorganic fine particles may be treated with a silane coupling agent or a titanium coupling agent. By the surface treatment, compatibility between the inorganic fine particles and the polysiloxane or the solvent is increased.

(1-5) Property of binder-type sealant

Preferably, a pH of the binder-type sealant is in a range of 1 to 4. If a pH is less than 1 or more than 4, the polysiloxane or the organic metal compound reacts and a precipitate or the like may be generated during storage. In order to adjust a pH of the binder-type sealant, a pH adjuster such as a nitric acid, or the like may be contained as necessary.

Further, the viscosity of the binder-type sealant is in a range of preferably 10 to 1000 cP, more preferably 12 to 800 cP, and still more preferably 20 to 600 cP. If the viscosity of the binder-type sealant is too low, during application of the binder-type sealant, the binder-type sealant may flow, and, thus, a sealing layer cannot be applied on a target area. On the other hand, if the viscosity of the binder-type sealant is too high, application of the binder-type sealant is difficult. Also, embedability of the LED element may be reduced. The viscosity may be adjusted depending on the amount of the inorganic fine particles or the like.

(1-6) Method of preparing binder-type sealant

The binder-type sealant is prepared by mixing the polysiloxane, the organic metal compound, and if necessary, the inorganic fine particles and the like with a solvent. The mixed solution can be prepared by a certain method by stirring with, for example, a stirrer mill, a blade kneader, or a thin-film spin dispersing machine.

(1-7) Use of binder-type sealant

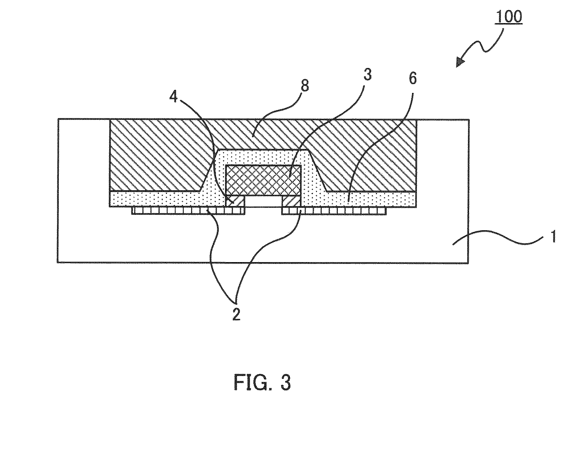

The binder-type sealant may be used, for example, to form sealing layer 6 of LED device 100 illustrated in FIG. 3. In LED device 100 configured as illustrated in FIG. 3, wavelength conversion layer 8 that converts a wavelength of a light emitted from LED chip 3 is further formed on sealing layer 6. In LED device 100, sealing layer 6 has a function of sealing LED element package 1, metal part 2, LED chip 3, and the like. Sealing layer 6 is formed by applying the binder-type sealant so as to cover LED element package 1, metal part 2, LED chip 3, and the like, and then drying and curing the binder-type sealant.

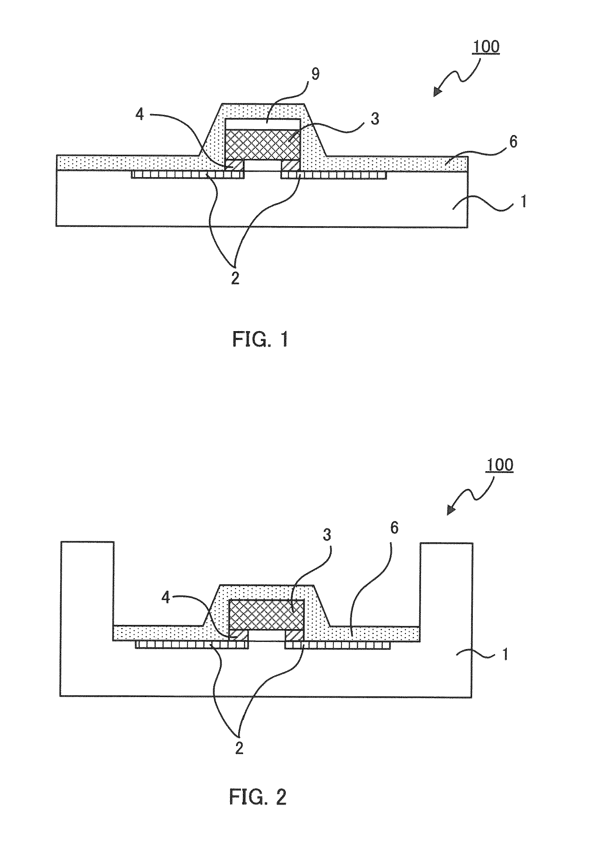

Further, the binder-type sealant may be used, for example, to form sealing layer 6 of LED device 100 illustrated in FIG. 1 or FIG. 2. In the LED device, sealing layer 6 has not only a function of sealing LED chip 3 or metal part 2 but also a function of converting a wavelength of a light emitted from LED chip 3. Sealing layer 6 of LED device 100 illustrated in FIG. 1 is formed by arranging phosphor particles in advance on glass substrate 9 for protecting package 1, metal part 2, and LED chip 3; and applying, drying, and curing the binder-type sealant on the phosphor particles.

(2) Phosphor-containing sealant

A phosphor-containing sealant contains a polysiloxane, an organic metal compound, a solvent, and phosphor particles, and may further contain laminar particles, inorganic fine particles, and the like as necessary.

(2-1) Polysiloxane

The polysiloxane contained in the phosphor-containing sealant may be the same as the polysiloxane contained in the binder-type sealant. The amount of the polysiloxane contained in the phosphor-containing sealant may be determined such that the amount of polysiloxane in a cured product of the phosphor-containing sealant is in a range of preferably 3 wt% or more to 35 wt% or less and preferably 10 wt% or more to 30 wt% or less.

The polysiloxane in the cured product of the phosphor-containing sealant functions as a binder. Thus, if the amount of the binder is less than 3 wt%, a cured film having a sufficient coating film strength cannot be obtained. On the other hand, if the amount of the polysiloxane is more than 35 wt%, the amount of the phosphor particles or the laminar particles is relatively decreased, and, thus, the viscosity of the phosphor-containing sealant is likely to decrease.

(2-2) Organic metal compound

An organic metal compound contained in the phosphor-containing sealant may be the same as the organic metal compound contained in the binder-type sealant. Further, the amount of the organic metal compound with respect to the amount of the polysiloxane may be the same as that of the binder-type sealant.

(2-3) Solvent

The solvent contained in the phosphor-containing sealant may either one of an aqueous solvent such as a combination of water and an organic solvent highly compatible with water, and a water-free, non-aqueous solvent which is an organic solvent less compatible with water. Herein, if the phosphor particles contained in the phosphor-containing sealant are easily degraded by water, a non-aqueous solvent is preferable.

On the other hand, if the phosphor particles contained in the phosphor-containing sealant are less degraded by water, an aqueous solvent is preferable as described above. Since water is contained, hydrolysis of the polysiloxane is promoted. Further, since water swells the laminar particles to be described later, the viscosity of the phosphor-containing sealant is increased. In this case, if water contains impurities, swelling of the laminar particles may be interrupted. Therefore, preferably, water contained in the phosphor-containing sealant does not contain any impurities.

(2-4) Phosphor particles

Phosphor particles are excited at a wavelength of an emission light from an LED chip (excitation wavelength) and emit fluorescence having a wavelength different from the excitation wavelength. For example, when a blue light is emitted from the LED chip, if phosphor particles emitting yellow fluorescence are contained in a cured film of the phosphor-containing sealant, a light emitted from the LED device becomes white. For example, the phosphor particles emitting yellow fluorescence may include a YAG (yttrium·aluminum·garnet) phosphor. The YAG phosphor can convert a blue light (wavelength: 420 nm to 485 nm) emitted from a blue LED element into a yellow light (wavelength: 550 nm to 650 nm).

The phosphor particles may be produced for example by the method including: 1) mixing as flux an appropriate amount of fluoride such as ammonium fluoride with a mixed raw material having a predetermined composition followed by pressing to produce a molded article; and 2) loading the molded article into in a crucible followed by calcination in air at 1,350 to 1,450°C for 2 to 5 hours.

The mixed raw material having a predetermined composition can be produced by fully mixing stoichiometric ratios of oxides of Y, Gd, Ce, Sm, Al, La, and Ga or compounds that are easily converted to the oxides at elevated temperatures. Alternatively, the mixed raw material having a predetermined composition can be produced by mixing a coprecipitate oxide, aluminum oxide and gallium oxide, wherein the coprecipitate oxide is one produced by coprecipitation using oxalic acid from a solution containing stoichiometric ratios of the rare earth elements Y, Gd, Ce, and Sm dissolved in acid.

The phosphor particles are not limited to YAG phosphor, and other phosphors, including Ce-free, non-garnet phosphor, can also be employed.

An average particle size of the phosphor particles is preferably 1 $\mu$m or more to 50 $\mu$m or less and more preferably 10 $\mu$m or less. Luminescence efficiency (wavelength conversion efficiency) increases as the phosphor particle size increases. On the other hand, when the particle size of the phosphor particles is too large, gaps formed at an interface between the phosphor particles and polysiloxane become large enough to cause a decrease in strength of the cured film of the phosphor-containing sealant. The average particle size of the phosphor particles can be measured, for example, by the Coulter counter method.

Preferably, the amount of the phosphor particles contained in the phosphor-containing sealant may be determined such that the amount of phosphor particles in the cured film of the phosphor-containing sealant is 60 to 95 wt%. Basically, the concentration of the phosphor particles in the cured film of the phosphor-containing sealant is preferable to be higher. When the concentration of the phosphor particles is increased, the content of the binder is reduced, and, thus, distribution of the phosphor particles in the cured film is likely to be uniform. When the concentration of the phosphor particles is increased, even if a cured film is thin, a require amount of the phosphor particles can be provided in the LED device.

Further, when the concentration of the phosphor particles in a cured film of the phosphor-containing sealant is increased, the phosphor particles adhere to one another, and, thus, the strength of the cured film of the phosphor-containing sealant is increased. Furthermore, when the concentration of the phosphor particles in the cured film is increased, heat emitted from the phosphor particles is likely to be radiated.

On the other hand, if the concentration of the phosphor particles in the cured film of the phosphor-containing sealant is too high (higher than 95 wt%), the content of the binder (polysiloxane) is so low that the phosphor particles may not bind to one another.

The concentration of the phosphor particles in the cured film can be obtained from the amount of the phosphor particles added in the phosphor-containing sealant.

(2-5) Laminar particles

The phosphor-containing sealant may contain laminar particles together with the phosphor particles. If the laminar particles are contained in the phosphor-containing sealant, the viscosity of the phosphor-containing sealant is increased and settling of the phosphor particles in this sealant is limited. The laminar particles form the card house structure in the phosphor-containing sealant. Therefore, when the laminar particles are contained, the viscosity of the phosphor-containing sealant is greatly increased.

A representative example of the laminar particles contained in the phosphor-containing sealant includes laminar clay mineral fine particles. A main component of the laminar clay mineral fine particles is a laminar silicate mineral. The laminar silicate mineral is preferably a swelling clay mineral having a mica structure, a kaolinite structure, or a smectite structure, more preferably a swelling clay mineral having a smectite structure, which exhibits good swelling property. Since the laminar clay mineral fine particles have a laminar structure, the strength of the cured film of the phosphor-containing sealant is also likely to be increased.

The amount of the laminar particles in the cured film of the phosphor-containing sealant is preferably 0.5 wt% or more to 20 wt% or less and more preferably 0.5 wt% or more to 10 wt% or less. If the content of the laminar particles in the cured film is less than 0.5 wt%, an effect of laminar particle addition cannot be sufficiently obtained. On the other hand, if the content of the laminar silicate mineral is more than 20 wt%, the strength of the phosphor-containing sealant is reduced.

Considering compatibility between the laminar particles and the solvent, the surface of the laminar clay mineral fine particles may be modified (surface-treated) with an ammonium salt or the like.

(2-6) Inorganic fine particles

The phosphor-containing sealant may contain inorganic fine particles. When the phosphor-containing sealant contains inorganic fine particles, the inorganic fine particles fill the gaps formed among the phosphor particles, and, thus, the strength of the cured film of the phosphor-containing sealant is increased. Further, when the inorganic fine particles are porous particles, the solvent seeps into voids of the porous particles, and, thus, the viscosity of the phosphor-containing sealant is effectively increased. Preferably, the inorganic fine particles have a specific surface area of 200 $m^2$/g or more.

Examples of the inorganic fine particles may include oxide fine particles of zirconium oxide, silicon oxide, titanium oxide, zinc oxide, and the like, and fluoride fine particles of magnesium fluoride and the like.

Considering the effects described above, an average particle size of the inorganic fine particles contained in the phosphor-containing sealant is in a range of preferably 1 nm to 50 $\mu$m, more preferably 1 nm to 10 $\mu$m, and still more preferably 1 nm to 100 nm. The average particle size of the inorganic fine particles can be measured, for example, by the Coulter counter method.

The amount of the inorganic fine particles in the phosphor-containing sealant may be determined such that the amount of the inorganic fine particles in the cured product of the phosphor-containing sealant is in a range of preferably 0.5 wt% or more to 50 wt% or less and more preferably 1 to 40 wt%. If the amount of the inorganic fine particles is less than 0.5 wt%, the gaps between the phosphor particles cannot be filled with the inorganic fine particles and the above-described effect of viscosity increase or the effect of film strength improvement cannot be obtained. Further, if the amount of the inorganic fine particles is less than 0.5 wt%, the amount of the phosphor particles is relatively increased, and, thus, handling property during application of the phosphor-containing sealant may be reduced. Therefore, it becomes difficult to form a layer having uniform chromaticity. On the other hand, if the amount of the inorganic fine particles is more than 50 wt%, the inorganic fine particles excessively scatter an excitation light from the LED element, and, thus, outcoupling efficiency of the LED device is reduced.

The surface of the inorganic fine particles may be treated with a silane coupling agent or a titanium coupling agent. By the surface treatment, compatibility between the inorganic fine particles and the polysiloxane increases.

(2-7) Property of phosphor-containing sealant

Preferably, a pH of the phosphor-containing sealant is in a range of 1 to 4. If a pH is less than 1 or more than 4, the polysiloxane or the organic metal compound easily reacts during storage and a precipitate or the like may be generated. In order to adjust a pH of the phosphor-containing sealant, a pH adjuster such as nitric acid or the like may be added as necessary.

The viscosity of the phosphor-containing sealant is in a range of preferably 10 to 1000 cP, more preferably 12 to 800 cP, and still more preferably 20 to 600 cP. If the viscosity of the phosphor-containing sealant is too low, during application of the phosphor-containing sealant, the phosphor-containing sealant may flow, and, thus, a sealing layer cannot be applied on a target area. On the other hand, if the viscosity of the phosphor-containing sealant is too high, application of the phosphor-containing sealant is difficult. Also, embedability of the LED element may be insufficient. The viscosity may be adjusted depending on the amount of the inorganic fine particles, the amount of the laminar particles, or the like.

(2-8) Method of preparing phosphor-containing sealant

The phosphor-containing sealant is prepared by mixing the phosphor particles, the polysiloxane, the organic metal compound, and, if necessary, the inorganic fine particles and the laminar particles with the solvent.

The order of mixing the components is not specifically limited, but if a part of the solvent is water, it is preferable that 1) the laminar particles (surface-treated to be lipophilic) are preliminarily mixed in a dispersion solvent other than water and then the polysiloxane, the organic metal compound, the phosphor particles, the inorganic fine particles, and water are added and mixed therein with stirring, or 2) the laminar particles (surface-treated to be lipophilic) are preliminarily mixed in water and then the polysiloxane, the organic metal compound, the phosphor particles, and an inorganic oxide are stirred in a dispersion solvent other than water. If the laminar particles are uniformly dispersed in the phosphor-containing sealant as such, the viscosity is likely to be increased.

Stirring of the mixed solution can be carried out using, for example, a stirrer mill, a blade kneader, or a thin-film spin dispersing machine. By adjusting the stirring conditions, settling of the phosphor particles in the phosphor-containing sealant can be limited.

(2-9) Use of phosphor-containing sealant

The phosphor-containing sealant may be used, for example, to form sealing layer 6 of LED device 100 illustrated in FIG. 1 or FIG. 2. In LED device 100, sealing layer 6 has not only a function of sealing LED chip 3 and metal part 2 but also a function of converting a wavelength of a light emitted from LED chip 3. Sealing layer 6 is formed by applying, drying, and curing the phosphor-containing sealant so as to cover glass substrate 9 for protecting LED element package 1, metal part 2, and LED chip 3.

2. LED device

The LED device of the present invention encompasses the following three LED devices. Each LED device has excellent sulfide gas resistance, and, thus, cracks or peeling-off do not easily occur in spite of long-term use.

(1) An LED device including an LED element and a sealing layer that seals the LED element, and the sealing layer is formed of a cured film of the above-described sealant for an LED device.
(2) An LED device including an LED element, a light transmissive layer that coats the LED element, and a wavelength conversion layer that is disposed to be in contact with the light transmissive layer, and the light transmissive layer is formed of a cured film of a composition for light transmissive layer containing polysiloxane, metal oxide fine particles, and a solvent.
(3) An LED device including an LED element, a primer layer that coats the LED element, a light transmissive layer that is disposed to be in contact with the primer layer, and a wavelength conversion layer that is disposed on the light transmissive layer.

(1) First LED device

A first LED device includes an LED element and a sealing layer that seals the LED element, and the sealing layer is formed of a cured film of the above-described sealant for an LED device. For example, the first LED device may include the LED element including package (LED substrate) 1 or LED chip 3, and sealing layer 6 that covers the LED element, as illustrated in FIG. 1 to FIG. 3. For example, as illustrated in FIG. 3, the LED device may further include wavelength conversion layer 8 for converting a light emitted from LED chip 3 into a light having another specific wavelength.

(1-1) LED element

The LED element includes package (LED substrate) 1, metal part 2, LED chip 3 disposed in package 1, and bump electrode 4 configured to connect metal part 2 with LED chip 3, as illustrated in FIG. 1 to FIG. 3. Further, as illustrated in FIG. 1, the LED element may include glass substrate 9 that coats LED chip 3.
Package 1 is made of, for example, a liquid crystal polymer or ceramic. The material thereof is not specifically limited as long as it has insulating property and heat resistance. Also, the shape thereof is not specifically limited. Package 1 may have a laminar shape as illustrated in FIG. 1, or a shape having a cavity as illustrated in FIG. 2 and FIG. 3.
LED chip 3 is, for example, a blue LED. For example, the blue LED has a configuration as a laminated body in which an n-GaN-based compound semiconductor layer (a clad layer), an InGaN-based compound semiconductor layer (a luminous layer), a p-GaN-based compound semiconductor layer (a clad layer), and a transparent electrode layer are stacked on LED substrate 1. LED chip 3 has a surface of, for example, 200 to 300 $\mu$m x 200 to 300 $\mu$m, and LED chip 3 has a height of about 50 to 200 $\mu$m.
Metal part 2 is an interconnection made of a metal such as silver, and may function as a reflector that reflects a light emitted from LED chip 3. Metal part 2 may be connected to the LED chip via bump electrode 4. An aspect where metal part 2 is connected to LED chip 3 via bump electrode 4 is referred to as "flip chip type", and an aspect where metal part 2 is connected to LED chip 3 via a metal interconnection is referred to as "wire bonding type".
Glass substrate 9 that covers a emission surface of LED chip 3 is disposed to protect the LED chip. Typically, glass substrate 9 has a thickness of 200 to 2000 $\mu$m.
In LED devices 100 illustrated in FIG. 1 to FIG. 3, only one LED chip 3 is disposed in package 1, but multiple LED chips 3 may be disposed in package 1.

(1-2) Sealing layer

Sealing layer 6 is formed of a cured film of the above-described sealant for an LED device. In sealing layer 6, (i) phosphor particles may be contained, or (ii) phosphor particles may not be contained.

(1-2-1) Case where phosphor particles are contained in sealing layer

If phosphor particles are contained in sealing layer 6, sealing layer 6 functions as a wavelength conversion site for converting a wavelength of a light emitted from the LED chip. Hereinafter, sealing layer 6 that contains the phosphor particles will be referred to as "wavelength conversion type sealing layer".
The thickness of wavelength conversion type sealing layer 6 is determined depending on the amount of phosphor required for the LED device, and, thus, it is not specifically limited. Herein, wavelength conversion type sealing layer 6 has a thickness of preferably 150 $\mu$m or less and more preferably 100 $\mu$m or less. If the thickness of wavelength conversion type sealing layer 6 is more than 150 $\mu$m, the concentration of the phosphor particles in wavelength conversion type sealing layer 6 is excessively decreased, and, thus, the phosphor particles may not be uniformly dispersed and a film strength may be decreased.

A lower limit of the thickness of wavelength conversion type sealing layer 6 is not specifically limited, but may be typically 15 μm or more and preferably 20 μm or more.

Preferably, the size of the phosphor particles and the size of the inorganic fine particles contained in wavelength conversion type sealing layer 6 are smaller than the thickness of wavelength conversion type sealing layer 6.

The thickness of wavelength conversion type sealing layer 6 means the maximum thickness of a layer disposed on a top surface of glass substrate 9 or a top surface of the emission surface of LED chip 3 (refer to FIG. 1 and FIG. 2). The thickness of wavelength conversion type sealing layer 6 disposed on the top surface of glass substrate 9 or the top surface of the emission surface of LED chip 3 means the maximum thickness thereof. The thickness of the layer can be measured with a laser hologage.

A method of forming wavelength conversion type sealing layer 6 is greatly classified into a method involving application of the above-described phosphor-containing sealant (one-pack type), and a method involving application of each of the above-described binder-type sealant and phosphor-containing sealant (two-pack type).

(One-pack type)

When wavelength conversion type sealing layer 6 is formed by the one-pack type method, the above-described phosphor-containing sealant is coated and cured on the above-described LED element.

The phosphor-containing sealant is applied so as to cover at least metal part (metal interconnection) 2, a side surface of LED chip 3 disposed in package 1, and glass substrate 9 of the LED element. Any coating method can be used; examples include blade coating method, spin coating method, dispenser coating method, and spray coating method. Among them, spray coating method is preferable since it is capable of easily forming a thin coating film and thus easily forming a thin ceramic layer.

After application of the phosphor-containing sealant, a coating film is heated at 100°C or higher and preferably 150 to 300°C, so that the polysiloxane and the organic metal compound are dried and cured. If a heating temperature is less than 100°C, water or the like generated during dehydration condensation of a silane compound cannot be removed sufficiently, and, thus, light resistance of the coating film may be decreased.

After wavelength conversion type sealing layer 6 is formed, wavelength conversion type sealing layer 6 may be further covered with a protection layer or the like. The protection layer is formed by a sprayer or a dispenser.

(Two-pack type)

When wavelength conversion type sealing layer 6 is formed by the two-pack type method, 1) a process of arranging phosphor particles by applying a phosphor dispersion liquid so as to cover the above-described LED element, and 2) a process of applying and curing the above-described binder-type sealant so as to coat the LED element on which the phosphor dispersion liquid is applied are carried out. According to this method, wavelength conversion type sealing layer 6 containing phosphor-containing particles therein is formed.

Process 1)

When wavelength conversion type sealing layer 6 is formed by the two-pack type method, phosphor particles are disposed by applying a phosphor dispersion liquid so as to coat the above-described LED element.

The phosphor dispersion liquid may be a dispersion liquid in which phosphor particles and laminar particles are dispersed in a solvent. The phosphor dispersion liquid may further contain inorganic fine particles. That is, the phosphor dispersion liquid may be the same as the phosphor-containing sealant except that polysiloxane and an organic metal compound are not contained.

Preferably, the solvent of the phosphor dispersion liquid may include alcohols. The alcohols may include monohydric alcohols such as methanol, ethanol, propanol, and butanol, and may include polyols having more than one hydroxyl group. Otherwise, two or more kinds of alcohols may be combined. If an alcohol having more than one hydroxyl group is contained, the viscosity of the phosphor dispersion liquid is likely to be increased, and, thus, setting of the phosphor particles as dispersoids can be limited.

The polyols having more than one hydroxyl group are not specifically limited, and examples thereof may include ethylene glycol, propylene glycol, diethylene glycol, glycerol, 1,3-butanediol, and 1,4-butanediol, with ethylene glycol, propylene glycol, 1,3-butanediol, 1,4-butanediol and the like being preferable.

The phosphor dispersion liquid is prepared in the same manner as the above-described phosphor-containing sealant. For example, the phosphor dispersion liquid is obtained by mixing phosphor particles into a solvent and then mixing laminar particles or inorganic fine particles with the mixed solvent.

Since the above-described one-pack type phosphor-containing sealant contains the solvent, the phosphor particles, the polysiloxane, the organic metal compound, the inorganic fine particles, the laminar particles, and the like, a chemical reaction occurs when time passes after preparation of the liquid. Thus, as time passes, viscosity may be increased. On the other hand, in the phosphor dispersion liquid that does not contain any binder-type sealant such as polysiloxane and an organic metal compound, such a chemical reaction does not occur, and, thus, the liquid has a long and stable pot life.

The phosphor dispersion liquid is applied so as to cover at least metal part (metal interconnection) 2, a side surface of LED chip 3 disposed in package 1, and glass substrate 9 of the LED element. Any coating method can be used; examples include blade coating method, spin coating method, dispenser coating method, and spray coating method. Among them, spray coating method is preferable since it is capable of easily forming a thin coating film. After application of the phosphor dispersion liquid, a coating film is dried as necessary.

Process 2)

The above-described binder-type sealant is applied so as to cover the LED element on which the phosphor dispersion liquid is applied. Any coating method can be used; examples include blade coating method, spin coating method, dispenser coating method, and spray coating method. Among them, spray coating method is preferable since it is capable of easily forming a thin coating film.

After application of the binder-type sealant, a coating film is heated at 100°C or higher and preferably 150 to 300°C, so that the polysiloxane and the organic metal compound are dried and cured. If a heating temperature is less than 100°C, organic components or the like generated during dehydration condensation of a silane compound cannot be removed sufficiently, and, thus, light resistance of the coating film may be decreased.

If wavelength conversion type sealing layer 6 is formed by the two-pack type method, the phosphor dispersion liquid and the binder-type sealant may be alternately and repeatedly applied on the LED element. After wavelength conversion type sealing layer 6 is formed, wavelength conversion type sealing layer 6 may be further covered with a protection layer or the like.

(1-2-2) Case where phosphor particles are not contained in sealing layer

If phosphor particles are not contained in sealing layer 6, as illustrated in FIG. 3, wavelength conversion layer 8 to be described later is additionally formed on sealing layer 6. If sealing layer 6 is included between the LED element and wavelength conversion layer 8, outcoupling efficiency of LED device 100 is increased for the following reason.

Since sealing layer 6 contains a metal element derived from the organic metal compound, a refractive index of sealing layer 6 is likely to be between a refractive index of a surface of the LED chip and a refractive index of wavelength conversion layer 8. As a result, interfacial reflection caused by a difference in refractive index between the layers is reduced, and outcoupling efficiency is increased as compared with a case where only wavelength conversion layer 8 is contained.

The thickness of sealing layer 6 is not specifically limited, but may be preferably 4 $\mu$m or less and more preferably 2 $\mu$m or less. Sealing layer 6 does not contain particles of 10 $\mu$m or more, and, thus, preferably, the thickness of sealing layer 6 is equal to or less than the above value in view of crack resistance. Meanwhile, a lower limit of the thickness of sealing layer 6 is not specifically limited, but may be typically 0.3 $\mu$m or more and preferably 1 $\mu$m or more.

Preferably, the size of the inorganic fine particles contained in sealing layer 6 is smaller than the thickness of sealing layer 6. The thickness of sealing layer 6 means the maximum thickness of a layer disposed on a top surface of LED chip 3. The thickness of the layer can be measured with a laser hologage.

Sealing layer 6 is formed by application of the above-described binder-type sealant. To be specific, the binder-type sealant is applied so as to cover metal part (metal interconnection) 2, LED chip 3 disposed in package 1, bump electrode 4 connecting metal part 2 and LED chip 3, and the emission surface of LED chip 3 of the LED element. Any coating method can be used; examples include blade coating method, spin coating method, dispenser coating method, and spray coating method. Among them, spray coating method is preferable since it is capable of easily forming a thin coating film.

After application of the binder-type sealant, a coating film is heated at 100°C or higher and preferably 150 to 300°C, so that the polysiloxane and the organic metal compound are dried and cured. If a heating temperature is lower than 100°C, water generated during dehydration condensation of a silane compound cannot be removed sufficiently, and, thus, light resistance of the coating film may be decreased.

(1-3) Wavelength conversion layer 8

Wavelength conversion layer 8 is a layer for converting an emission wavelength of the LED chip and is stacked on the above-described sealing layer 6 (the sealing layer that does not contain phosphor particles). Wavelength conversion layer 8 is a layer in which phosphor particles are dispersed in a transparent resin. The phosphor particles contained in wavelength conversion layer 8 may be the same as those contained in the above-described sealant for an LED device (phosphor-containing sealant). The transparent resin contained in wavelength conversion layer 8 may be a transparent thermosetting resin. To be specific, the transparent resin may be a silicone resin, an epoxy resin or the like, with a silicone resin being most preferable.

The film thickness of wavelength conversion layer 8 is determined depending on the amount of phosphor required for the LED device, and, thus, it is not specifically limited. Typically, wavelength conversion layer 8 has a thickness of preferably 25 $\mu$m to 5 mm and more preferably 1 to 3 mm. If the thickness of wavelength conversion layer 8 exceeds the upper limit, typically, the concentration of the phosphor particles in wavelength conversion layer 8 is excessively decreased, and, thus, the phosphor particles may not be uniformly dispersed.

The concentration of the phosphor particles in wavelength conversion layer 8 is preferably 5 to 15 wt% and more preferably 9 to 11 wt%.

According to a method of forming wavelength conversion layer 8, phosphor particles are dispersed in a liquid transparent resin (thermosetting resin), and this dispersion liquid is applied on sealing layer 6 using an injector such as a dispenser. Then, this dispersion liquid may be heated and cured.

(2) Second LED device

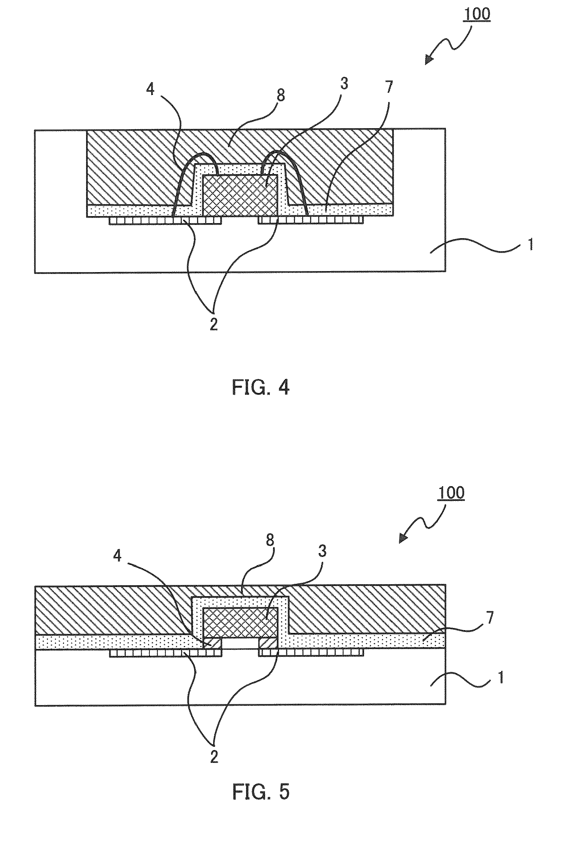

A second LED device includes an LED element, light transmissive layer 7, and wavelength conversion layer 8 as illustrated in FIG. 4 and FIG. 5. Light transmissive layer 7 is a cured film of a composition for light transmissive layer containing polysiloxane, metal oxide fine particles, and a solvent.

(2-1) LED element

The LED element includes package (LED substrate) 1, metal part 2, LED chip 3 disposed in package 1, and metal interconnection or bump electrode 4 configured to connect metal part 2 with LED chip 3, as illustrated in FIG. 4 and FIG. 5. The LED element may include a glass substrate (not illustrated) that coats LED chip 3. The LED element of the second LED device may be the same as the LED element of the first LED device.

(2-2) Light transmissive layer

Light transmissive layer 7 is a cured film of a composition for light transmissive layer containing polysiloxane, metal oxide fine particles, and a solvent and coats the above-described LED element. The coating of the LED element means coating of at least a emission surface and metal part 2 of LED chip 3. For example, as illustrated in FIG. 4, LED package 1 or metal interconnection 4 may not be completely coated.

Since light transmissive layer 7 coats metal part 2, erosion of metal part 2 caused by elapse of time can be prevented and outcoupling efficiency can be maintained high over a long period of time. When light transmissive layer 7 is formed on the emission surface of LED chip 3, a light from LED chip 3 is scattered and outcoupling efficiency is increased.

The thickness of light transmissive layer 7 is preferably 0.5 to 10 $\mu$m, more preferably 0.8 to 5 $\mu$m, and still more preferably 1 to 2 $\mu$m. If the thickness of the light transmissive layer is 0.5 $\mu$m or less, it is difficult to form a film to a uniform thickness. If the thickness of the light transmissive layer is 10 $\mu$m or more, a strength of light transmissive layer 7 may not be sufficient. The thickness of light transmissive layer 7 means the maximum thickness of a layer disposed on a top surface of LED chip 3 of the LED element. The thickness of light transmissive layer 7 can be measured with a laser hologage.

In the composition for light transmissive layer used for forming a light transmissive layer, polysiloxane, metal oxide fine particles, and a solvent are contained, and a metal alkoxide or metal chelate, or various additives may be contained as necessary.

(2-2-1) Polysiloxane

Polysiloxane may be a polymer of monomers containing a tetrafunctional silane compound. The monomers may contain not only the tetrafunctional silane compound, but also a trifunctional silane compound or a bifunctional silane compound. The amount of the tetrafunctional silane compound contained in the monomers is preferably 20 to 80 wt% and more preferably 30 to 70 wt%. If a content of the tetrafunctional silane compound is too high, a degree of cross-linking of the polysiloxane is increased and contraction occurs during film formation, and, thus, a film is likely to be cracked. On the other hand, if a content of the tetrafunctional silane compound is too low, a large amount of organic groups derived from the trifunctional silane compound or the bifunctional silane compound remain in light transmissive layer 7. As a result, wettability of a composition for forming wavelength conversion layer 8 is reduced and adhesion between light transmissive layer 7 and wavelength conversion layer 8 is reduced.

The monomers may contain preferably the tetrafunctional silane compound and the trifunctional silane compound, and particularly preferably the tetrafunctional silane compound and a trifunctional monomethylsilane compound. That is, preferably, the polysiloxane is a polymer of monomers comprised of the tetrafunctional silane compound and the trifunctional monomethylsilane compound. A polymerization ratio thereof is not specifically limited, but a polymerization molar ratio is preferably 3:7 to 7:3 and more preferably 4:6 to 6:4.

The tetrafunctional silane compound contained in the monomers may be the same as the tetrafunctional silane compound for preparation of polysiloxane of the above-described sealant for an LED device. On the other hand, the trifunctional silane compound contained in the monomers may be trifunctional monomethylsilane for preparation of polysiloxane of the above-described sealant for an LED device, or the following compounds.

Examples of the trifunctional silane compound except trifunctional monomethylsilane may include monohydrosilane compounds such as trimethoxysilane, triethoxysilane, tripropoxysilane, tripentyloxysilane, triphenyloxysilane, dimethoxymonoethoxysilane, diethoxymonomethoxysilane, dipropoxymonomethoxysilane, dipropoxymonoethoxysilane, dipentyloxylmonomethoxysilane, dipentyloxymonoethoxysilane, dipentyloxymonopropoxysilane, diphenyloxylmonomethoxysilane, diphenyloxymonoethoxysilane, diphenyloxymonopropoxysilane, rnethoxyethoxypropoxysilane, monopropoxydimethoxysilane, monopropoxydiethoxysilane, monobutoxydimethoxysilane, monopentyloxydiethoxysilane, and monophenyloxydiethoxysilane; monoethylsilane compounds such as ethyltrimethoxysilane, ethyltripropoxysilane, ethyltripentyloxysilane, ethyltriphenyloxysilane, ethyimonomethoxydiethoxysilane, ethylmonomethoxydipropoxysilane, ethylmonomethoxydipentyloxysilane, ethylmonomethoxydiphenyloxysilane, and ethylmonomethoxymonoethoxymonobutoxysilane; monopropylsilane compounds such as propyltrimethoxysilane, propyltriethoxysilane, propyltripentyloxysilane, propyltriphenyloxysilane, propylmonomethoxydiethoxysilane, propylmonomethoxydipropoxysilane, propylmonomethoxydipentyloxysilane, propylmonomethoxydiphenyloxysilane, propylmethoxyethoxypropoxysilane, and propylmonomethoxymonoethoxymonobutoxysilane; and monobutylsilane compounds such as butyltrimethoxysilane, butyltriethoxysilane, butyltripropoxysilane, butyltripentyloxysilane, butyltriphenyloxysilane, butylmonomethoxydiethoxysilane, butylmonomethoxydipropoxysilane, butylmonomethoxydipentyloxysilane, butylmonomethoxydiphenyloxysilane, butylmethoxyethoxypropoxysilane, and butylmonomethoxymonoethoxymonobutoxysilane. Among them, methyltrimethoxysilane and methyltriethoxysilane are preferable, and methyltrimethoxysilane is more preferable.

The bifunctional silane compound contained in the monomers may be a compound expressed by the following general formula (V):

$$R^5{}_2Si(OR^4)_2 \qquad\qquad (V)$$

In general formula (V) above, each $R^4$ independently represents an alkyl group or a phenyl group, and preferably represents an alkyl group having 1 to 5 carbon atoms or phenyl group. Each $R^5$ independently represents a hydrogen atom or an alkyl group.

Specific examples of the bifunctionalsilane compound include dimethoxysilane, diethoxysilane, dipropoxysilane, dipentyloxysilane, diphenyloxysilane, methoxyethoxysilane, methoxypropoxysilane, methoxypentyloxysilane, methoxyphenyloxysilane, ethoxypropoxysilane, ethoxypentyloxysilane, ethoxyphenyloxysilane, methyldimethoxysilane, methylmethoxyethoxysilane, methyldiethoxysilane, methylmethoxypropoxysilane, methylmethoxypentyloxysilane, methylmethoxyphenyloxysilane, ethyldipropoxysilane, ethylmethoxypropoxysilane, ethyldipentyloxysilane, ethyldiphenyloxysilane, propyldimethoxysilane, propylmethoxyethoxysilane, propylethoxypropoxysilane, propyldiethoxysilane, propyldipentyloxysilane, propyldiphenyloxysilane, butyldimethoxysilane, butylmethoxyethoxysilane, butyldiethoxysilane, butylethoxypropoxysilane, butyldipropoxysilane, butylmethyldipentyloxysilane, butylmethyldiphenyloxysilane, dimethyldimethoxysilane, dimethylmethoxyethoxysilane, dimethyldiethoxysilane, dimethyldipentyloxysilane, dimethyldiphenyloxysilane, dimethylethoxypropoxysilane, dim ethyldipropoxysi lane, diethyldimethoxysilane, diethylmethoxypropoxysilane, diethyldiethoxysilane, diethylethoxypropoxysilane, dipropyldimethoxysilane, dipropyldiethoxysilane, dipropyldipentyloxysilane, dipropyldiphenyloxysilane, dibutyldimethoxysilane, dibutyldiethoxysilane, dibutyldipropoxysilane, dibutylmethoxypentyloxysilane, dibutylmethoxyphenyloxysilane, methylethyldimethoxysilane, methylethyldiethoxysilane, methylethyldipropoxysilane, methylethyldipentyloxysilane, methylethyldiphenyloxysilane, methylpropyldimethoxysilane, methylpropyldiethoxysilane, methylbutyldimethoxysilane, methylbutyldiethoxysilane, methylbutyldipropoxysilane, methylethylethoxypropoxysilane, ethylpropyldimethoxysilane, ethylpropylmethoxyethoxysilane, dipropyldimethoxysilane, dipropylmethoxyethoxysilane, propylbutyldimethoxysilane, propylbutyldiethoxysilane, dibutylmethoxyethoxysilane, dibutylmethoxypropoxysilane, and dibutylethoxypropoxysilane. Among them, dimethoxysilane, diethoxysilane, methyldimethoxysilane, and methyldiethoxysilane are preferable.

A weight-average molecular weight of the polysiloxane is preferably 1000 to 3000, more preferably 1200 to 2700, and still more preferably 1500 to 2000. When the weight-average molecular weight of the polysiloxane is less than 1000, the viscosity is reduced so that repelling of liquid may easily occur while the light transmissive layer is formed. On the other hand, when the weight-average molecular weight is more than 3000, the viscosity is increased so that it may be difficult to form a uniform film or the embedability of the LED element may be reduced. The weight-average molecular weight is a value measured by gel-permeation chromatography (in terms of polystyrene).

The polysiloxane can be obtained by hydrolyzing and condensing the monomers containing the tetrafunctional silane compound and the trifunctional silane compound under the presence of an acid catalyst, water, and an organic solvent, which may be the same as the method of preparing polysiloxane contained in the above-described sealant for an LED device.

(2-2-2) Metal oxide fine particles

The composition for light transmissive layer contains metal oxide fine particles. If the metal oxide fine particles are contained in the cured film of the composition for light transmissive layer, that is, light transmissive layer 7, irregularity is provided on a surface of light transmissive layer 7 and an anchor effect is expressed between light transmissive layer 7 and wavelength conversion layer 8. By the irregularity, wettability of the composition for forming wavelength conversion layer 8 is improved and adhesion between light transmissive layer 7 and wavelength conversion layer 8 is increased.

When the metal oxide fine particles are contained in light transmissive layer 7, the metal oxide fine particles scatter a light from LED chip 3, and thus, outcoupling efficiency of LED device 100 is increased. Also, film strength of light transmissive layer 7 is improved. When the metal oxide fine particles are contained in the composition for light transmissive layer, a stress generated in a film during polycondensation or drying of polysiloxane is relieved, and thus, light transmissive layer 7 is not easily cracked.

A kind of the metal oxide fine particles is not specifically limited, but particles having a high refractive index are preferable. If metal oxide fine particles having a high refractive index are contained, a refractive index of light transmissive layer 7 is increased. As a result, a refractive index is gradually varied from the LED element in order of the LED element, light transmissive layer 7, wavelength conversion layer 8, and the atmosphere, and reflection at interfaces between the respective layers is limited. Thus, the outcoupling effect of LED device 100 is increased.

Preferably, the metal oxide fine particles are oxide fine particles containing one or more metals selected from the group consisting of zirconium, titanium, tin, cerium, tantalum, niobium, and zinc. Only one of them may be contained, or two or more of them may be contained. These metal oxide fine particles have a high refractive index. As a result, a refractive index of light transmissive layer 7 is likely to be between a refractive index of a surface of LED chip 3 and a refractive index of wavelength conversion layer 8. Among them, zirconium oxide fine particles are preferable as the metal oxide fine particles considering that the zirconium oxide fine particles have a particularly high refractive index, which results in a high effect of improving the refractive index of light transmissive layer 7.

An average primary particle size of the metal oxide fine particles is preferably 5 to 100 nm, more preferably 5 to 80 nm, and still more preferably 5 to 50 nm. When the average primary particle size of the metal oxide fine particles is in the above-described range, fine irregularities are likely to be formed on a surface of the light transmissive layer. Further, a light scattering effect can be easily obtained. The average primary particle size of the metal oxide fine particles can be measured by the Coulter counter method.

Preferably, the metal oxide fine particles are porous particles and have a specific surface area of 200 $m^2/g$ or more. If the metal oxide fine particles are porous particles, a solvent is mixed into void portions of the porous particles, and thus, the viscosity of the composition for light transmissive layer can be effectively increased. However, the viscosity of the composition for light transmissive layer is not determined just by the amount of the metal oxide fine particles, but varies depending on a ratio between the metal oxide fine particles and the solvent or amounts of the other components.

The amount of the metal oxide fine particles in the composition for light transmissive layer is preferably 10 to 60 wt%, more preferably 15 to 45 wt%, and still more preferably 20 to 30 wt%. If the amount of the metal oxide fine particles is too small, the anchor effect, the light scattering effect, and the effect of refractive index decrease cannot be obtained sufficiently. On the other hand, if the amount is too large, the amount of the polysiloxane is relatively decreased and the strength of the light transmissive layer may be decreased.

The surface of the metal oxide fine particles may be treated with a silane coupling agent or a titanium coupling agent. By the surface treatment, compatibility between the metal oxide fine particles and the polysiloxane is increased.

(2-2-3) Solvent

The solvent contained in the composition for light transmissive layer is not specifically limited. The solvent may be an aqueous solvent which is a combination of water and an organic solvent highly compatible with water, or a non-aqueous solvent as an organic solvent less compatible with water without containing water. Examples of the organic solvent highly compatible with water may include alcohols such as methanol, ethanol, propanol, and butanol.

In the present invention, the solvent is preferably an aqueous solvent and the solvent includes preferably water. The amount of water is preferably 3 to 15 wt% and more preferably 5 to 10 wt% with respect to the total amount of the composition for light transmissive layer. The amount of water is preferably 10 to 120 parts by weight and more preferably 80 to 100 parts by weight with respect to 100 parts by weight of the polysiloxane. If the amount of water is too small, the polysiloxane is not sufficiently hydrolyzed while the light transmissive layer is formed and a moist-heat resistance of the light transmissive layer is not sufficiently increased. On the other hand, if the amount of water is too large, hydrolysis may occur while the composition for light transmissive layer is stored and preserved, and thus, gelation can occur.

The solvent preferably includes an organic solvent having a boiling point of 150°C or higher, such as ethylene glycol or propylene glycol. When the composition for light transmissive layer contains an organic solvent having a boiling point of 150°C or higher, a storage stability of the composition for light transmissive layer can be improved, and thus, the composition for light transmissive layer can be stably applied with an applicator. On the other hand, when the solvent has a boiling point of 250°C or lower, a drying property of the composition for light transmissive layer is increased.

(2-2-4) Organic metal compound

The composition for light transmissive layer may contain an organic metal compound formed of a metal alkoxide or metal chelate containing metal elements except an element Si. While the light transmissive layer is formed, the organic metal compound forms a metal-oxane bonding with the polysiloxane or a hydroxyl group present in a surface of the LED element or the wavelength conversion layer. The metal-oxane bonding is very strong and firm. Therefore, when the organic metal compound is contained, adhesion between light transmissive layer 7 and the LED element and adhesion between light transmissive layer 7 and wavelength conversion layer 8 are increased.

A part of the organic metal compound forms a nanoscale cluster formed by the metal-oxane bonding in light transmissive layer 7. This cluster can oxidize a sulfide gas which is present around LED device 100 and highly corrosive to metal and can also convert the gas into a sulfurous dioxide gas less corrosive to metal due to photocatalytic activity.

The metal element contained in the organic metal compound is preferably Group 4 or Group 13 metal elements except an element Si. The organic metal compound may be the same as the organic metal compound contained in the above-described sealant for an LED device.

(2-2-5) Method of preparing composition for light transmissive layer

The composition for light transmissive layer is prepared by adding polysiloxane, metal oxide fine particles, an organic metal compound, and various additives to the solvent so as to produce a mixed solution and stirring the mixed solution. The order of adding the components is not specifically limited.

Stirring of the mixed solution can be carried out using, for example, a stirrer mill, a blade kneader, or a thin-film spin dispersing machine. By adjusting the stirring conditions, settling of the metal oxide fine particles can be limited.

(2-2-6) Method of forming light transmissive layer

Light transmissive layer 7 is formed by applying the above-described composition for light transmissive layer so as to cover at least metal part (metal interconnection) 2 and the emission surface of LED chip 3 disposed in package 1 of the LED element. Any coating method can be used; examples include blade coating method, spin coating method, dispenser coating method, and spray coating method. Among them, spray coating method is preferable since it is capable of easily forming a thin coating film and thus easily forming a thin light transmissive layer.

After application of the composition for light transmissive layer, a coating film is heated at 100°C or higher and preferably 150 to 300°C, so that the polysiloxane is dried and cured. When the heating temperature is less than 100°C, organic components or the like generated during dehydration condensation cannot be removed sufficiently, and thus, light resistance of light transmissive layer 7 may decrease.

(2-3) Wavelength conversion layer

Wavelength conversion layer 8 is a layer for converting a light having a specific wavelength emitted from LED chip 3 into a light having another specific wavelength. Wavelength conversion layer 8 may be a layer in which phosphor particles are dispersed in a transparent resin. Wavelength conversion layer 8 may be the same as the above-described wavelength conversion layer of the first LED device.

(3) Third LED device

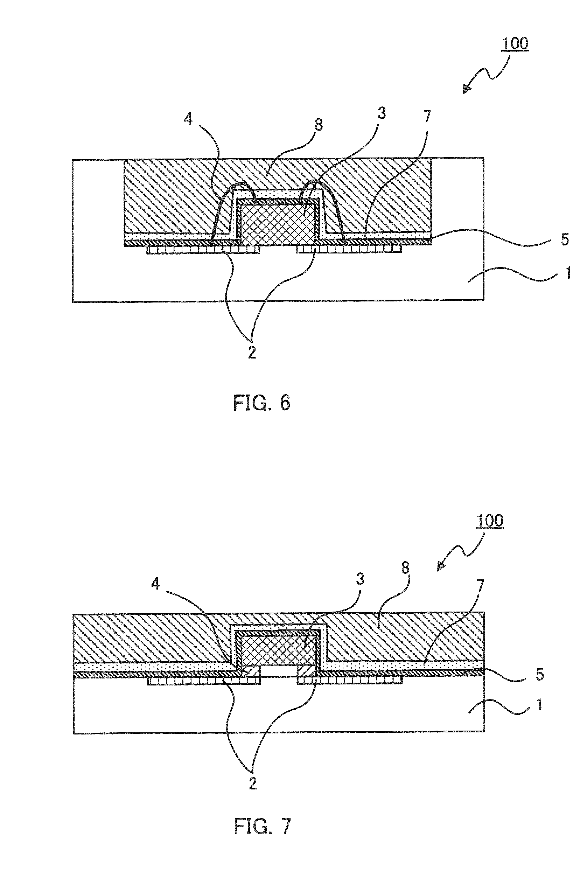

A third LED device includes an LED element, primer layer 5, light transmissive layer 7, and wavelength conversion layer 8 as illustrated in FIG. 6 and FIG. 7.

(3-1) LED element

The LED element includes package (LED substrate) 1, metal part 2, LED chip 3 disposed in package 1, and metal interconnection or bump electrode 4 configured to connect metal part 2 with LED chip 3, as illustrated in FIG. 6 and FIG. 7. The LED element may include a glass substrate (not illustrated) that coats LED chip 3. The LED element of the third LED device may be the same as the LED element of the first LED device.

(3-2) Primer layer

Primer layer 5 coats the LED element, and light transmissive layer 7 to be described later is stacked on primer layer 5. The coating of the LED element means coating of at least a emission surface and metal part 2 of LED chip 3 as illustrated in FIG. 6. Package 1 or interconnection 4 may not be completely coated. However, preferably, primer layer 5 coats a part of package 1.

Primer layer 5 is a cured film of a composition for primer layer containing an organic metal monomer having a reactive functional group and a solvent. Primer layer 5 has a function of increasing adhesion between the LED element and light transmissive layer 7. To be specific, a metal of an organic metal monomer contained in primer layer 5 forms a strong and firm metal-oxane bonding with each of a hydroxyl group present in a surface of LED chip 3 or a surface of metal part 2, and polysiloxane contained in the light transmissive layer. Therefore, in the LED device of the present invention, LED chip 3 or metal part 2 and light transmissive layer 7 are strongly and firmly bonded via primer layer 5, and even when a load is applied due to a change in temperature, layer separation does not occur therebetween.

The thickness of primer layer 5 is not specifically limited, but is preferably smaller than a wavelength (for example, blue light (420 nm to 485 nm)) emitted from LED chip 3, more preferably 10 to 120 nm, and still more preferably 20 to 90 nm. If the thickness of primer layer 5 is smaller than the wavelength, an effect of primer layer 5 on outcoupling efficiency of LED device 100 is greatly decreased. The thickness of primer layer 5 means the maximum thickness of primer layer 5 disposed on LED chip 3. The thickness of the thickness of primer layer 5 can be measured with a laser hologage.

A surface of primer layer 5 contains preferably 10 at.% to 35 at.% and more preferably 20 at.% to 30 at.% of a metal element derived from the organic metal monomer with respect to all elements present in the surface. When the amount of the metal element is 10 at.% or more, the metal element sufficiently contributes to the above-described metal-oxane bonding and adhesion between the LED element and light transmissive layer 7 is improved. The amount of metal element can be measured by X-ray electron spectroscopy.

Primer layer 5 is formed by applying and drying the LED element with a composition for primer layer containing an organic metal monomer and a solvent. The composition for primer layer contains an organic metal monomer and a solvent and may further contain various additives such as a stabilizer if necessary.

(3-2-1) Organic metal monomer

The organic metal monomer is a monomer having a metal element and a reactive functional group and also a compound that forms a metal-oxane boding through hydrolysis-polycondensation. Herein, the term "reactive functional group" means a group that generates a highly reactive hydroxyl group through hydrolysis with water.

To be specific, preferably, the organic metal monomer is a metal alkoxide or metal chelate (an organic metal compound) expressed by the following general formula (VI):

$$M^{m} + X_{n}Y_{m-n} \quad \cdots (VI)$$

In general formula (VI), M represents a metal element. Further, m represents a valence of M and represents 2 to 4. n represents the number of X groups and is an integer of 2 or more and 4 or less. Herein, m is equal to or greater than n.

The metal element represented by M is preferably silane, titanium, or zirconium, and particularly preferably, zirconium. A film formed of a metal-oxane polymer of zirconium does not have an absorption wavelength in an emission wavelength region (particularly, a blue light (wavelength: 420 nm to 485 nm)) of a general LED chip. That is, primer layer 5 containing a zirconium-based metal element does not absorb but transmits a light emitted from an LED element. Thus, the outcoupling property is improved.

In general formula (VI) above, X represents a reactive functional group. As described above, the number of reactive functional groups (n) of the organic metal monomer is 2 to 4 and preferably 3 or 4. By setting the number of reactive functional groups is 3 or 4, a metal in the organic metal monomer easily forms a close metal-oxane bonding with a hydroxyl group present in a surface of LED chip 3 or a surface of metal part 2, and polysiloxane contained in the light transmissive layer. Thus, adhesion between the LED element and light transmissive layer 7 is increased.

The reactive functional group represented by X may include a lower alkoxy group having 1 to 5 carbon atoms, an acetoxy group, a butane oxime group, a chloro group, and the like. Multiple Xs may be the same reactive functional groups or may be a combination of multiple species. The reactive functional group is preferably a lower alkoxy group having 1 to 5 carbon atoms and more preferably a methoxy group or an ethoxy group considering that a component to be separated after reaction is neutral. Since they are sufficiently reactive and the component (methanol or ethanol) to be separated boils fast, it is possible to easily remove them.

In general formula (VI) above, Y represents a monovalent organic group. Examples of the monovalent organic group may include a publicly-known group as a monovalent organic group of a so-called silane coupling agent. To be specific, Y represents an aliphatic group, an alicyclic group, an aromatic group, and an alicyclic aromatic group having 1 to 1,000 carbon atoms, preferably 500 or less carbon atoms, more preferably 100 or less carbon atoms, still more preferably 50 or less carbon atoms, and particularly preferably 6 or less carbon atoms. They may have an atom such as O, N, or S, or an atom group as a linking group. Among them, preferably, the monovalent organic group is a methyl group considering that light resistance and heat resistance of the primer layer can be improved.

The organic group may have a substituent. Examples of the substituent may include: halogen atoms such as F, Cl, Br, and I,; and organic functional groups such as a vinyl group, a methacryloxy group, an acryloxy group, a styryl group, a mercapto group, an epoxy group, an epoxy cyclohexyl group, a glycidoxy group, an amino group, a cyano group, a nitro group, a sulfonic acid group, a carboxyl group, a hydroxyl group, an acyl group, an alkoxy group, an imino group, and a phenyl group.

A specific example of the organic metal monomer may be the same compound as the specific example of the organic metal compound contained in the above-described sealant for an LED device.

(3-2-2) Solvent

The solvent contained in the composition for primer layer may be capable of dissolving or uniformly dispersing the above-described organic metal monomer. Examples of the solvent may include monohydric alcohols such as methanol, ethanol, propanol, and n-butanol; alkylcarboxylic esters such as methyl-3-methoxypropionate, and ethyl-3-ethoxypropionate; polyols such as ethylene glycol, diethylene glycol, propylene glycol, glycerin, trimethylol propane, and hexane triol; monoethers of polyols such as ethylene glycol monomethyl ether, ethylene glycol monoethyl ether, ethylene glycol monopropyl ether, ethylene glycol monobutyl ether, diethylene glycol monomethyl ether, diethylene glycol monoethyl ether, diethylene glycol monopropyl ether, diethylene glycol monobutyl ether, propylene glycol monomethyl ether, propylene glycol monoethyl ether, propylene glycol monopropyl ether, and propylene glycol monobutyl ether, or monoacetates thereof; esters such as acetic acid methyl, acetic acid ethyl, and acetic acid butyl; ketones such as acetone, methylethylketone, and methylisoamylketone; and polyol ethers alkyletherified from all hydroxylic groups of polyols such as ethylene glycol dimethyl ether, ethylene glycol diethyl ether, ethylene glycol dipropyl ether, ethylene glycol dibutyl ether, propylene glycol dimethyl ether, propylene glycol diethyl ether, diethylene glycol dimethyl ether, diethylene glycol diethyl ether, and diethylene glycol methylethyl ether. One of these solvents may be used alone, or two or more of these solvents may be combined.

The amount of the solvent is preferably 200 to 1,500 parts by weight, more preferably 300 to 1,200 parts by weight, and still more preferably 500 to 900 parts by weight with respect to 100 parts by weight of the organic metal monomer. If the amount of the solvent is too large, when the composition for primer layer is applied and dried, it takes time to dry. On the other hand, if the amount of the solvent is too small, the viscosity of the composition for primer layer is increased, and thus, the composition for primer layer may not be uniformly applied.

(3-2-3) Preparation of composition for primer layer

The composition for primer layer is prepared by adding the above-described organic metal monomer and various additives to the solvent so as to produce a mixed solution and stirring the mixed solution. The order of adding the components is not specifically limited. Stirring of the mixed solution can be carried out using, for example, a stirrer mill, a blade kneader, or a thin-film spin dispersing machine.

(3-2-4) Method of forming primer layer

The primer layer is formed by applying the above-described composition for primer layer so as to cover at least metal part (metal interconnection) 2 and the emission surface of LED chip 3 disposed in package 1 of the LED element. Any coating method can be used; examples include blade coating method, spin coating method, dispenser coating method, and spray coating method. Among them, spray coating method is preferable since it is capable of easily forming thin primer layer 5.

As for the amount of the composition for primer layer to be applied, the amount of the organic metal monomer is preferably 0.3 to 3.0 $\mu$l and more preferably 0.5 to 1.0 $\mu$l per 1 mm$^2$. By setting the amount of the organic metal monomer to such a range, the primer layer can be formed on metal part 2 or the emission surface of LED chip 3 without unevenness.

After application of the composition for primer layer, the solvent is dried. Drying may be carried out at room temperature but preferably 60 to 90°C and more preferably 70 to 80°C. When the temperature is within this range, the solvent is efficiently dried.

(3-3) Light transmissive layer

Preferably, light transmissive layer 7 is formed on at least LED chip 3 and metal part 2 of the LED element via primer layer 5. Light transmissive layer 7 has a function of preventing erosion of metal part 2 and a function of protecting LED chip 3 from external shocks or the like.

The thickness of the light transmissive layer is preferably 0.5 to 10 $\mu$m, more preferably 0.8 to 5 $\mu$m, and sill more preferably 1 to 2 $\mu$m. If the thickness of the light transmissive layer is 0.5 $\mu$m or less, it is difficult to form a film to have a uniform thickness. If the thickness of the light transmissive layer is 10 $\mu$m or more, a film strength may be decreased. The thickness of the light transmissive layer means the maximum thickness of the light transmissive layer disposed on a top surface of LED chip 3. The thickness of the layer can be measured with a laser hologage.

Light transmissive layer 7 is formed by coating the above-described primer layer 5 with a composition for light transmissive layer containing a polysiloxane and a solvent followed by calcining. Any coating method can be used; examples include blade coating method, spin coating method, dispenser coating method, and spray coating method. Among them, spray coating method is preferable since it is capable of easily forming a thin coating film and thus easily forming a thin light transmissive layer.

After application of the composition for light transmissive layer, a coating film is heated at 100°C or higher and preferably 150 to 300°C, so that the polysiloxane is dried and cured. If the heating temperature is less than 100°C, water or the like generated during dehydration condensation cannot be removed sufficiently, and thus, light resistance of the light transmissive layer may decrease.

The composition for light transmissive layer contains a polysiloxane and a solvent and further contains metal oxide fine particles, an organic metal compound, and various additives as necessary. The polysiloxane, the metal oxide fine particles, and the organic metal compound contained in the composition for light transmissive layer may be the same as the polysiloxane, the metal oxide fine particles, and the organic metal compound contained in the composition for light transmissive layer of the second LED device. The added amounts and preparation methods may also be the same as those of the composition for light transmissive layer of the second LED device.

(3-4) Wavelength conversion layer

Wavelength conversion layer 8 is a layer for converting a light having a specific wavelength emitted from LED chip 3 into a light having another specific wavelength. Wavelength conversion layer 8 may be a layer in which phosphor particles are dispersed in a transparent resin. Wavelength conversion layer 8 may be the same as the above-described wavelength conversion layer of the first LED device.

[Use of LED device]

The above-described LED device can be various kinds of optical members with additional optical components (lens or the like). In particular, since the LED device of the present invention is excellent in sulfide gas resistance, light resistance, heat resistance, and the like, it is suitable for vehicle lighting or exterior lighting.

Examples

Hereinafter, the present invention will be described in more detail with reference to Examples, which however shall not be construed as limiting the present invention.

Evaluation methods in Examples will be described below.

1. Example of first LED device

<Evaluation of repelling of liquid>

A sealant for an LED device was applied on an LED chip to a wet film thickness of 8 $\mu$m with a sprayer (TS-MSP-400, manufactured by Taitech Solutions). Whether or not droplets due to repelling of liquid are formed on the emission surface of the LED chip, a silver reflector, and a resin package was evaluated by the following criteria.

- No droplets are formed on all of the emission surface, the silver reflector, and the resin package: B
- No droplets are formed on the emission surface, the silver reflector, but droplets formed on the resin package with a contact angle of less than 40°: C
- Droplets are formed on all of the emission surface, the silver reflector, and the resin package with a contact angle of 40° or more: D

<Evaluation of film surface smoothness>

The sealant for an LED device was applied on a slide glass cleaned with acetone with a sprayer (TS-MSP-400, manufactured by Taitech Solutions) and then calcined at 150°C for 1 hour. A surface shape of a coating film was measured with an interferometric surface profiler (WYKO NT9000, manufactured by Veeco), and a film surface smoothness was evaluated by the following criteria.

- A centerline average roughness Ra of the coating film is less than 200 nm: B
- A centerline average roughness Ra of the coating film is 200 nm or more to less than 250 nm: C
- A centerline average roughness Ra of the coating film is 250 nm or more: D

<Evaluation of sulfide gas resistance>

Based on a gas exposure test (JIS C 60068-2-43) according to JIS standard, the produced LED devices were exposed to an atmosphere with a hydrogen sulfide gas of 15 ppm (temperature: 25°C, relative humidity: 75% RH) for 1,000 hours. With respect to each of the LED devices, a total luminous flux was measured before and after exposure, and a sulfide gas resistance was evaluated by the following criteria.

- A ratio of total luminous flux to initial luminous flux (the total luminous flux after exposure to the sulfide gas/the total luminous flux before exposure to the sulfide gas x 100) is 96% or more: B
- A ratio of total luminous flux to initial luminous flux (the total luminous flux after exposure to the sulfide gas/the total luminous flux before exposure to the sulfide gas x 100) is 92% or more to less than 96%: C
- A ratio of total luminous flux to initial luminous flux (the total luminous flux after exposure to the sulfide gas/the total luminous flux before exposure to the sulfide gas x 100) is less than 92%: D

<Evaluation of crack resistance>

The outward appearance of a sealing layer of each of the produced LED devices was observed through a scanning electron microscope (SEM) (VE7800, manufactured by Keyence) at magnification of 1,000 times. With respect to each of them, crack resistance was evaluated by the following criteria.

- The sealing layer has no crack having a length of 10 $\mu$m or more: B
- The sealing layer has 1 or more to less than 5 cracks having a length of 10 $\mu$m or more: C
- The sealing layer has 5 or more cracks having a length of 10 $\mu$m or more: D

<Evaluation of pot life>

The sealant for an LED device was settled at room temperature for 3 weeks. Then, a precipitate was measured with a dynamic light scattering particle size measurement device (Desla nano S, manufactured by Beckman Coulter), and a pot life was evaluated by the following criteria.

- No fine particle is generated in the sealant for an LED device: B

- Fine particles or gelled materials having a size of 100 nm or more to 500 nm or less are generated in the sealant for an LED device: C
- Particles or gelled materials having a size of more than 500 nm are generated in the sealant for an LED device: D

<Evaluation of light resistance>

The sealant for an LED device was applied and calcined on a slide glass. In this case, coating films were stacked such that a film thickness after calcination was 1.5 µm. With respect to the slide glass, a light transmittance before and after a test with 150 mW for 100 hours using a metal halide lamp light resistance tester (M6T, manufactured by SUGA TEST INSTRUMENTS CO., LTD.) was measured, and light resistance was evaluated by the following criteria.

- A decrease in average transmittance of the treated sample at 300 nm to 500 nm is less than 1.0%: B
- A decrease in average transmittance of the treated sample at 300 nm to 500 nm is 1.0% or more to less than 1.5%: C
- A decrease in average transmittance of the treated sample at 300 nm to 500 nm is 1.5% or more: D

<Evaluation of moist-heat resistance>

The produced LED devices were settled for 1,000 hours at a temperature of 60°C and a relative humidity of 90% RH. With respect to each of the LED devices, a total luminous flux was measured before and after test, and a moist-heat resistance was evaluated by the following criteria.

- A ratio of total luminous flux to initial luminous flux (the total luminous flux after test/the total luminous flux before test x 100) is 96% or more: B
- A ratio of total luminous flux to initial luminous flux (the total luminous flux after test/the total luminous flux before test x 100) is 92% or more to less than 96%: C
- A ratio of total luminous flux to initial luminous flux (the total luminous flux after test/the total luminous flux before test x 100) is less than 92%: D

<Evaluation of outcoupling property>

The outcoupling property of the produced LED devices was measured using a spectral emission luminance meter (CS-1000, manufactured by KONICA MINOLTA, INC.). According to measurement conditions, a current of 10 mA was applied. Evaluation was made with relative values based on 1.0 as a total luminous flux of an LED device without a sealing layer.

- A relative value is 1.1 or more: A
- A relative value is in a range of 1.03 to 1.09: B
- A relative value is in a range of 0.98 to 1.02 : C
- A relative value is 0.97 or less: D

[Preparation of phosphor]

Hereinafter, a method of preparing a phosphor will be described.
7.41 g of $Y_2O_3$, 4.01 g of $Gd_2O_3$, 0.63 g of $CeO_2$, and 7.77 g of $Al_2O_3$ as phosphor materials were fully mixed. An appropriate amount of ammonium fluoride as flux was mixed therewith, and a crucible made of aluminum was filled with the mixture. The filler was calcined at a temperature in a range of 1350 to 1450°C for 2 to 5 hours under a reducing atmosphere in which a hydrogen-containing nitrogen gas was circulated. As a result, a calcined product $((Y_{0.72}Gd_{0.24})_3Al_5O_{12}:Ce_{0.04})$ was obtained.
The obtained calcined product was ground, cleaned, separated, and dried, so that yellow phosphor particles having an average particle size of about 10 µm were obtained. When an emission wavelength of an excitation light having a wavelength of 465 nm was measured, a peak wavelength was at about 570 nm.

[Method for producing LED devices (LED devices 1-1 to 1-60)]

Hereinafter, a method for producing LED devices (LED devices 1-1 to 1-60) having the configuration illustrated in FIG. 1 will be described.

Example 1 <Production of LED device 1-1>

47.3 g of methyltrimethoxysilane, 13.1 g of tetramethoxysilane, 40.0 g of methanol, and 40.0 g of acetone were mixed with stirring. Then, 54.6 g of water and 4.7 $\mu$L of 60% nitric acid were added thereto with further stirring for 3 hours. Then, the mixture was aged at 26°C for 2 days. The obtained composition was diluted with methanol to a solid value of polysiloxane of 10%. As a result, a polysiloxane solution having a polymerization molar ratio of a trifunctional monomethylsilane compound to a tetrafunctional silane compound of 8:2 and a pH of 4 was obtained.

Then, 3.0 g of acetyl acetone (produced by Kanto Chemical Co., Inc.) as a stabilizer and 0.57 g of ZC580 (produced by Matsumoto Fine Chemical Co., Ltd.) as a Zr chelate were added to 20.0 g of the polysiloxane solution with stirring. As a result, a Zr chelate-containing sealant (binder-type sealant) for an LED device was obtained.

1 g of phosphor particles prepared by the above-described method, 0.05 g of MK-100 (synthesized mica, produced by CO-OP CHEMICAL CO., LTD.), 0.05 g of RX300 (an average particle size of primary particles: 7 nm, a specific surface area: 300 $m^2$/g, produced by Nippon Aerosil Co., Ltd.), and 1.5 g of propylene glycol were mixed so as to prepare a phosphor dispersion liquid (two-pack type). By spray coating, the prepared phosphor dispersion liquid was applied on an LED element (LED chip) configured as illustrated in FIG. 1 and dried at 50°C for 1 hour, and, thus, phosphor particles were disposed on the LED element.

The LED element was an LED chip-mounting package in which a single blue LED chip (rectangular parallele-piped shape: 200 $\mu$m x 300 $\mu$m x 100 $\mu$m) was flip chip-mounted on a central portion of the laminar package, and a glass substrate (200 $\mu$m x 300 $\mu$m x 500 $\mu$m) was disposed on the LED chip.

By spray coating, the above-described Zr chelate-containing sealant (binder-type sealant) for LED device was then applied on the phosphor particles disposed by the above-described method. Thereafter, calcination was carried out at 150°C for 1 hour, and, thus, phosphor-containing sealing layer 6 was prepared. As a result, LED device 1-1 including a sealing layer (a wavelength conversion type sealing layer) containing phosphor particles with a thickness of 20 $\mu$m was obtained.

Example 2 <Production of LED device 1-2>

LED device 1-2 was obtained in the same manner as LED device 1-1 except that when a sealant for an LED device was prepared, a mixed solution including methyltrimethoxysilane, tetramethoxysilane, methanol, acetone, water, and nitric acid was stirred for 6 hours.

Example 3 <Production of LED device 1-3>

LED device 1-3 was obtained in the same manner as LED device 1-1 except that methyltrimethoxysilane was added in the amount of 41.3 g and tetramethoxysilane was added in the amount of 19.8 g.

Example 4 <Production of LED device 1-4>

LED device 1-4 was obtained in the same manner as LED device 1-3 except that when a sealant for an LED device was prepared, a mixed solution including methyltrimethoxysilane, tetramethoxysilane, methanol, acetone, water, and nitric acid was stirred for 6 hours.

Example 5 <Production of LED device 1-5>

LED device 1-5 was obtained in the same manner as LED device 1-1 except that methyltrimethoxysilane was added in the amount of 29.4 g and tetramethoxysilane was added in the amount of 32.9 g.

Example 6 <Production of LED device 1-6>

LED device 1-6 was obtained in the same manner as LED device 1-5 except that when a sealant for an LED device was prepared, a mixed solution including methyltrimethoxysilane, tetramethoxysilane, methanol, acetone, water, and nitric acid was stirred for 4.5 hours.

Example 7 <Production of LED device 1-7>

LED device 1-7 was obtained in the same manner as LED device 1-5 except that when a sealant for an LED device was prepared, a mixed solution including methyltrimethoxysilane, tetramethoxysilane, methanol, acetone, water, and nitric acid was stirred for 6 hours.

Example 8 <Production of LED device 1-8>

LED device 1-8 was obtained in the same manner as LED device 1-1 except that methyltrimethoxysilane was added in the amount of 17.7 g and tetramethoxysilane was added in the amount of 46.1 g.

Example 9 <Production of LED device 1-9>

LED device 1-9 was obtained in the same manner as LED device 1-8 except that when a sealant for an LED device was prepared, a mixed solution including methyltrimethoxysilane, tetramethoxysilane, methanol, acetone, water, and nitric acid was stirred for 6 hours.

Example 10 <Production of LED device 1-10>

LED device 1-10 was obtained in the same manner as LED device 1-1 except that methyltrimethoxysilane was added in the amount of 11.7 g and tetramethoxysilane was added in the amount of 52.8 g.

Example 11 <Production of LED device 1-11>

LED device 1-11 was obtained in the same manner as LED device 1-10 except that when a sealant for an LED device was prepared, a mixed solution including methyltrimethoxysilane, tetramethoxysilane, methanol, acetone, water, and nitric acid was stirred for 6 hours.

Comparative Example 1 <Production of LED device 1-12>

LED device 1-12 was obtained in the same manner as LED device 1-1 except that methyltrimethoxysilane was added in the amount of 29.4 g and dimethoxydimethylsilane was added in the amount of was 26.0 g instead of tetramethoxysilane.

Comparative Example 2 <Production of LED device 1-13>

LED device 1-13 was obtained in the same manner as LED device 1-12 except that when a sealant for an LED device was prepared, a mixed solution including methyltrimethoxysilane, dimethoxydimethylsilane, methanol, acetone, water, and nitric acid was stirred for 6 hours.

Comparative Example 3 <Production of LED device 1-14>

LED device 1-14 was obtained in the same manner as LED device 1-12 except that when a sealant for an LED device was prepared, a mixed solution including methyltrimethoxysilane, dimethoxydimethylsilane, methanol, acetone, water, and nitric acid was stirred for 0.5 hours.

Comparative Example 4 <Production of LED device 1-15>

LED device 1-15 was obtained in the same manner as LED device 1-12 except that when a sealant for an LED device was prepared, a mixed solution including methyltrimethoxysilane, dimethoxydimethylsilane, methanol, acetone, water, and nitric acid was stirred for 8 hours.

Comparative Example 5 <Production of LED device 1-16>

LED device 1-16 was obtained in the same manner as LED device 1-1 except that when a polysiloxane solution was prepared, tetramethoxysilane was not added and methyltrimethoxysilane was added in the amount of 59.0 g.

Comparative Example 6 <Production of LED device 1-17>

LED device 1-17 was obtained in the same manner as LED device 1-16 except that when a sealant for an LED device was prepared, a mixed solution including methyltrimethoxysilane, methanol, acetone, water, and nitric acid was stirred for 6 hours.

Comparative Example 7 <Production of LED device 1-18>

LED device 1-18 was obtained in the same manner as LED device 1-16 except that when a sealant for an LED device was prepared, a mixed solution including methyltrimethoxysilane, methanol, acetone, water, and nitric acid was stirred for 0.5 hours.

Comparative Example 8 <Production of LED device 1-19>

LED device 1-19 was obtained in the same manner as LED device 1-16 except that when a sealant for an LED device was prepared, a mixed solution including methyltrimethoxysilane, methanol, acetone, water, and nitric acid was stirred for 8 hours.

Comparative Example 9 <Production of LED device 1-20>

LED device 1-20 was obtained in the same manner as LED device 1-1 except that when a sealant for an LED device was prepared, a mixed solution including methyltrimethoxysilane, tetramethoxysilane, methanol, acetone, water, and nitric acid was stirred for 0.5 hours.

Comparative Example 10 <Production of LED device 1-21>

LED device 1-21 was obtained in the same manner as LED device 1-1 except that when a sealant for an LED device was prepared, a mixed solution including methyltrimethoxysilane, tetramethoxysilane, methanol, acetone, water, and nitric acid was stirred for 8 hours.

Comparative Example 11 <Production of LED device 1-22>

LED device 1-22 was obtained in the same manner as LED device 1-3 except that when a sealant for an LED device was prepared, a mixed solution including methyltrimethoxysilane, tetramethoxysilane, methanol, acetone, water, and nitric acid was stirred for 0.5 hours.

Comparative Example 12 <Production of LED device 1-23>

LED device 1-23 was obtained in the same manner as LED device 1-3 except that when a sealant for an LED device was prepared, a mixed solution including methyltrimethoxysilane, tetramethoxysilane, methanol, acetone, water, and nitric acid was stirred for 8 hours.

Comparative Example 13 <Production of LED device 1-24>

LED device 1-24 was obtained in the same manner as LED device 1-5 except that when a sealant for an LED device was prepared, a mixed solution including methyltrimethoxysilane, tetramethoxysilane, methanol, acetone, water, and nitric acid was stirred for 0.5 hours.

Comparative Example 14 <Production of LED device 1-25>

LED device 1-25 was obtained in the same manner as LED device 1-5 except that when a sealant for an LED device was prepared, a mixed solution including methyltrimethoxysilane, tetramethoxysilane, methanol, acetone, water, and nitric acid was stirred for 8 hours.

Comparative Example 15 <Production of LED device 1-26>

LED device 1-26 was obtained in the same manner as LED device 1-8 except that when a sealant for an LED device was prepared, a mixed solution including methyltrimethoxysilane, tetramethoxysilane, methanol, acetone, water, and nitric acid was stirred for 0.5 hours.

Comparative Example 16 <Production of LED device 1-27>

LED device 1-27 was obtained in the same manner as LED device 1-8 except that when a sealant for an LED device was prepared, a mixed solution including methyltrimethoxysilane, tetramethoxysilane, methanol, acetone, water, and nitric acid was stirred for 0.5 hours.

Comparative Example 17 <Production of LED device 1-28>

LED device 1-28 was obtained in the same manner as LED device 1-10 except that when a sealant for an LED device was prepared, a mixed solution including methyltrimethoxysilane, tetramethoxysilane, methanol, acetone, water, and nitric acid was stirred for 0.5 hours.

Comparative Example 18 <Production of LED device 1-29>

LED device 1-29 was obtained in the same manner as LED device 1-10 except that when a sealant for an LED device was prepared, a mixed solution including methyltrimethoxysilane, tetramethoxysilane, methanol, acetone, water, and nitric acid was stirred for 8 hours.

Comparative Example 19 <Production of LED device 1-30>

LED device 1-30 was obtained in the same manner as LED device 1-1 except that when a sealant for an LED device was prepared, methyltrimethoxysilane was not added and tetramethoxysilane was added in the amount of 65.9 g.

Comparative Example 20 <Production of LED device 1-31>

LED device 1-31 was obtained in the same manner as LED device 1-30 except that when a sealant for an LED device was prepared, a mixed solution including tetramethoxysilane, methanol, acetone, water, and nitric acid was stirred for 6 hours.

Comparative Example 21 <Production of LED device 1-32>

LED device 1-32 was obtained in the same manner as LED device 1-30 except that when a sealant for an LED device was prepared, a mixed solution including tetramethoxysilane, methanol, acetone, water, and nitric acid was stirred for 0.5 hours.

Comparative Example 22 <Production of LED device 1-33>

LED device 1-33 was obtained in the same manner as LED device 1-30 except that when a sealant for an LED device was prepared, a mixed solution including tetramethoxysilane, methanol, acetone, water, and nitric acid was stirred for 8 hours.

Example 12 <Production of LED device 1-34>

LED device 1-34 was obtained in the same manner as LED device 1-6 except that a Zr chelate ZC580 (produced by Matsumoto Fine Chemical Co., Ltd.) was added in the amount of 0.14 g.

Example 13 <Production of LED device 1-35>

LED device 1-35 was obtained in the same manner as LED device 1-6 except that a Zr chelate ZC580 (produced by Matsumoto Fine Chemical Co., Ltd.) was added in the amount of 2.85 g.

Example 14 <Production of LED device 1-36>

LED device 1-36 was obtained in the same manner as LED device 1-6 except that 0.1 g of Ti alkoxide TA25 (produced by Matsumoto Fine Chemical Co., Ltd.) was added instead of a Zr chelate ZC580 (produced by Matsumoto Fine Chemical Co., Ltd.).

Example 15 <Production of LED device 1-37>

LED device 1-37 was obtained in the same manner as LED device 1-6 except that 0.4 g of Ti alkoxide TA25 (produced by Matsumoto Fine Chemical Co., Ltd.) was added instead of a Zr chelate ZC580 (produced by Matsumoto Fine Chemical Co., Ltd.).

Example 16 <Production of LED device 1-38>

LED device 1-38 was obtained in the same manner as LED device 1-6 except that 2.0 g of Ti alkoxide TA25 (produced by Matsumoto Fine Chemical Co., Ltd.) was added instead of a Zr chelate ZC580 (produced by Matsumoto Fine Chemical Co., Ltd.).

Example 17 <Production of LED device 1-39>

LED device 1-39 was obtained in the same manner as LED device 1-6 except that 0.1 g of Al alkoxide ALR15GB (produced by Kojundo Chemical Lab. Co., Ltd.) was added instead of a Zr chelate ZC580 (produced by Matsumoto Fine Chemical Co., Ltd.).

Example 18 <Production of LED device 1-40>

LED device 1-40 was obtained in the same manner as LED device 1-6 except that 0.4 g of Al alkoxide ALR15GB (produced by Kojundo Chemical Lab. Co., Ltd.) was added instead of a Zr chelate ZC580 (produced by Matsumoto Fine Chemical Co., Ltd.).

Example 19 <Production of LED device 1-41>

LED device 1-41 was obtained in the same manner as LED device 1-6 except that 2.0 g of Al alkoxide ALR15GB (produced by Kojundo Chemical Lab. Co., Ltd.) was added instead of a Zr chelate ZC580 (produced by Matsumoto Fine Chemical Co., Ltd.).

Comparative Example 23 <Production of LED device 1-42>

LED device 1-42 was obtained in the same manner as LED device 1-6 except that a Zr chelate ZC580 (produced by Matsumoto Fine Chemical Co., Ltd.) was not added.

Comparative Example 24 <Production of LED device 1-43>

LED device 1-43 was obtained in the same manner as LED device 1-6 except that a Zr chelate ZC580 (produced by Matsumoto Fine Chemical Co., Ltd.) was added in the amount of 4.28 g.

Comparative Example 25 <Production of LED device 1-44>

LED device 1-44 was obtained in the same manner as LED device 1-6 except that 3.0 g of Ti alkoxide TA25 (produced by Matsumoto Fine Chemical Co., Ltd.) was added instead of a Zr chelate ZC580 (produced by Matsumoto Fine Chemical Co., Ltd.).

Comparative Example 26 <Production of LED device 1-45>

LED device 1-45 was obtained in the same manner as LED device 1-6 except that 3.0 g of Al alkoxide ALR15GB (produced by Kojundo Chemical Lab. Co., Ltd.) was added instead of a Zr chelate ZC580 (produced by Matsumoto Fine Chemical Co., Ltd.).

Example 20 <Production of LED device 1-46>

LED device 1-46 was obtained in the same manner as LED device 1-6 except that 0.2 g of pure water was added to a sealant for an LED device.

Example 21 <Production of LED device 1-47>

LED device 1-47 was obtained in the same manner as LED device 1-6 except that 1.2 g of pure water was added to a sealant for an LED device.

Example 22 <Production of LED device 1-48>

LED device 1-48 was obtained in the same manner as LED device 1-6 except that 2.4 g of pure water was added to a sealant for an LED device.

Example 23 <Production of LED device 1-49>

LED device 1-49 was obtained in the same manner as LED device 1-47 except that nitric acid was added to a sealant for an LED device until a pH measured with a pH meter (YK-21 PH, manufactured by Sato Shoji Corporation) reached a value of 0.8.

Example 24 <Production of LED device 1-50>

LED device 1-50 was obtained in the same manner as LED device 1-47 except that nitric acid was added to a sealant for an LED device until a pH measured with a pH meter (YK-21 PH, manufactured by Sato Shoji Corporation) reached a value of 1.0.

Example 25 <Production of LED device 1-51>

LED device 1-51 was obtained in the same manner as LED device 1-47 except that nitric acid was added to a sealant for an LED device until a pH measured with a pH meter (YK-21 PH, manufactured by Sato Shoji Corporation) reached a value of 4.0.

Example 26 <Production of LED device 1-52>

LED device 1-52 was obtained in the same manner as LED device 1-47 except that nitric acid was added to a sealant for an LED device until a pH measured with a pH meter (YK-21 PH, manufactured by Sato Shoji Corporation) reached a value of 5.0.

Example 27 <Production of LED device 1-53>

LED device 1-53 was obtained in the same manner as LED device 1-49 except that 2.0 g of slurry (SZR-M, produced by Sakai Chemical Industry Co., Ltd.) in which $ZrO_2$ fine particles were dispersed was added to a sealant for an LED device.

Example 28 <Production of LED device 1-54>

LED device 1-54 was obtained in the same manner as LED device 1-50 except that 2.0 g of slurry (SZR-M, produced by Sakai Chemical Industry Co., Ltd.) in which $ZrO_2$ fine particles were dispersed was added to a sealant for an LED device.

Example 29 <Production of LED device 1-55>

LED device 1-55 was obtained in the same manner as LED device 1-51 except that 2.0 g of slurry (SZR-M, produced by Sakai Chemical Industry Co., Ltd.) in which $ZrO_2$ fine particles were dispersed was added to a sealant for an LED device.

Example 30 <Production of LED device 1-56>

LED device 1-56 was obtained in the same manner as LED device 1-52 except that 2.0 g of slurry (SZR-M, produced by Sakai Chemical Industry Co., Ltd.) in which $ZrO_2$ fine particles were dispersed was added to a sealant for an LED device.

Example 31 <Production of LED device 1-57>

LED device 1-57 was obtained in the same manner as LED device 1-49 except that a sealant for an LED device was calcined at 80°C.

Example 32 <Production of LED device 1-58>

LED device 1-58 was obtained in the same manner as LED device 1-50 except that a sealant for an LED device was calcined at 100°C.

Example 33 <Production of LED device 1-59>

LED device 1-59 was obtained in the same manner as LED device 1-53 except that a sealant for an LED device was calcined at 80°C.

Example 34 <Production of LED device 1-60>

LED device 1-60 was obtained in the same manner as LED device 1-54 except that a sealant for an LED device was calcined at 100°C.

Evaluation results for the LED devices according to Examples 1 to 11 and Comparative Examples 1 to 22 were as shown in Table 1.

[Table 1]

| | LED No. | Sealant | | | | Evaluation | | | |
|---|---|---|---|---|---|---|---|---|---|
| | | Silane compound polymerization ratio | Polysiloxane weight-average molecular weight | Organic metal compound | Amount of organic metal compound added [parts by weight] | Repelling of liquid | Film surface smoothness | Sulfide resistance | Crack resistance |
| Example 1 | 1-1 | Trifunctional: tetrafunctional= 8:2 | 1000 | Zr chelate | 20 | C | B | B | B |
| Example 2 | 1-2 | | 3000 | Zr chelate | 20 | C | B | B | B |
| Example 3 | 1-3 | Trifunctional: tetrafunctional= 7:3 | 1000 | Zr chelate | 20 | B | B | B | B |
| Example 4 | 1-4 | | 3000 | Zr chelate | 20 | B | B | B | B |
| Example 5 | 1-5 | Trifunctional: tetrafunctional= 5:5 | 1000 | Zr chelate | 20 | B | B | B | B |
| Example 6 | 1-6 | | 2000 | Zr chelate | 20 | B | B | B | B |
| Example 7 | 1-7 | | 3000 | Zr chelate | 20 | B | B | B | B |
| Example 8 | 1-8 | Trifunctional:tetrafunctional= 3:7 | 1000 | Zr chelate | 20 | B | B | B | B |
| Example 9 | 1-9 | | 3000 | Zr chelate | 20 | B | B | B | B |
| Example 10 | 1-10 | Trifunctional: tetrafunctional=2:8 | 1000 | Zr chelate | 20 | B | B | C | C |
| Example 11 | 1-11 | | 3000 | Zr chelate | 20 | B | B | C | C |
| Comparative Example 1 | 1-12 | | 1000 | Zr chelate | 20 | D | B | D | B |
| Comparative Example 2 | 1-13 | Bifunctional: trifunctional= 5:5 | 3000 | Zr chelate | 20 | D | B | D | B |
| Comparative Example 3 | 1-14 | | 500 | Zr chelate | 20 | D | C | D | B |
| Comparative Example 4 | 1-15 | | 4000 | Zr chelate | 20 | D | D | D | B |

EP 2 800 154 A1

(continued)

| | LED No. | Sealant | | | | | Evaluation | | | |
|---|---|---|---|---|---|---|---|---|---|---|
| | | Silane compound polymerization ratio | Polysiloxane weight-average molecular weight | Organic metal compound | Amount of organic metal compound added [parts by weight] | | Repelling of liquid | Film surface smoothness | Sulfide resistance | Crack resistance |
| Comparative Example 5 | 1-16 | Only trifunctional | 1000 | Zr chelate | 20 | | D | B | D | B |
| Comparative Example 6 | 1-17 | | 3000 | Zr chelate | 20 | | D | B | D | B |
| Comparative Example 7 | 1-18 | | 500 | Zr chelate | 20 | | D | C | D | B |
| Comparative Example 8 | 1-19 | | 4000 | Zr chelate | 20 | | D | D | D | B |
| Comparative Example 9 | 1-20 | Trifunctional: tetrafunctional= 8:2 | 500 | Zr chelate! | 20 | | D | C | D | B |
| Comparative Example 10 | 1-21 | | 4000 | Zr chelate j | 20 | | B | D | D | B |
| Comparative Example 11 | 1-22 | Trifunctional: tetrafunctional= 7:3 | 500 | Zr chelate | 20 | | D | C | D | B |
| Comparative Example 12 | 1-23 | | 4000 | Zr chelate | 20 | | B | D | D | B |
| Comparative Example 13 | 1-24 | Trifunctional: tetrafunctional= 5:5 | 500 | Zr chelate | 20 | | D | C | D | B |
| Comparative Example 14 | 1-25 | | | Zr chelate | 20 | | B | D | D | B |
| Comparative Example 15 | 1-26 | Trifunctional: tetrafunctional= 3:7 | 500 | Zr chelate | 20 | | D | C | D | B |
| Comparative Example 16 | 1-27 | | 4000 | Zr chelate | 20 | | B | D | D | B |

34

(continued)

| | LED No. | Sealant | | | | Evaluation | | | |
|---|---|---|---|---|---|---|---|---|---|
| | | Silane compound polymerization ratio | Polysiloxane weight-average molecular weight | Organic metal compound | Amount of organic metal compound added [parts by weight] | Repelling of liquid | Film surface smoothness | Sulfide resistance | Crack resistance |
| Comparative Example 17 | 1-28 | Trifunctional:tetrafunctional= 2:8 | 500 | Zr chelate | 20 | D | C | D | C |
| Comparative Example 18 | 1-29 | | 4000 | Zr chelate | 20 | B | D | D | C |
| Comparative Example 19 | 1-30 | Only tetrafunctional | 1000 | Zrchelate | 20 | B | B | D | D |
| Comparative Example 20 | 1-31 | | 3000 | Zr chelate | 20 | B | B | D | D |
| Comparative Example 21 | 1-32 | | 500 | Zr chelate | 20 | B | C | D | D |
| Comparative Example 22 | 1-33 | | 4000 | Zr chelate | 20 | B | D | D | D |

As can be clearly seen from Table 1 above, in all of Examples 1 to 11 including a cured film of polysiloxane having a weight-average molecular weight of 1,000 to 3,000 and formed by polymerization of a trifunctional monomethylsilane compound and a tetrafunctional silane compound, repelling of the sealant for LED device was hardly observed and film surface smoothness was improved.

Even in the case of using polysiloxane formed by polymerization of a trifunctional monomethylsilane compound and a tetrafunctional silane compound, when a weight-average molecular weight was less than 1,000, a surface shape of a coating film is not maintained at the irregularity and repelling of liquid occurred (Comparative Examples 9, 11, 13, 15, and 17). This is because a film was not sufficiently formed due to an excessive low viscosity of the sealant for LED device.

On the other hand, when a weight-average molecular weight of the polysiloxane was 3,000 or more, repelling of liquid did not occur. However, when the sealant for an LED device were sprayed with the sprayer, droplets were overly increased in size, and, thus, a good film surface smoothness could not be obtained (Comparative Examples 10, 12, 14, 16, and 18).

In the case of using a bifunctional component and a trifunctional component (Comparative Examples 1 to 4), and in the case of using only a trifunctional component (Comparative Example 5 to Comparative Example 8) as silane compounds constituting polysiloxane, repelling of liquid occurred on the metallic reflector and the metallic electrode, and, thus, a uniform film could not be obtained. This is because in the polysiloxane formed of the bifunctional component or the trifunctional component, or in the polysiloxane formed of the trifunctional component only, a large amount of organic groups were bonded to the polysiloxane chain. The degree of cross-linking of the polysiloxane was not sufficient and sulfide gas resistance was low.

Meanwhile, in Comparative Examples 19 to 22 using a tetrafunctional component only as a silane compound constituting polysiloxane, repelling of liquid was not observed, but the film was less flexible and was cracked.

Even in the case of using a trifunctional component and a tetrafunctional component as silane compounds constituting polysiloxane, when a polymerization ratio (molar ratio) of the trifunctional component to the tetrafunctional component was 8:2, repelling of liquid was somewhat observed (Examples 1 and 2). This is because the amount of organic groups derived from the trifunctional component and bonded to the polysiloxane chain was increased. In the case of using the trifunctional component and the tetrafunctional component, when the polymerization ratio (molar ratio) of the trifunctional component to the tetrafunctional component was 2:8, the flexibility of the film was decreased, and crack resistance and a sulfide gas resistance were somewhat decreased (Examples 10 and 11).

Evaluation results for the LED devices according to Examples 6 and 12 to 19, and Comparative Examples 23 to 26 were as shown in Table 2.

[Table 2]

| | LED No. | Sealant | | | | LED optical property evaluation | | Sealant property evaluation |
|---|---|---|---|---|---|---|---|---|
| | | Silane compound polymerization ratio | Polysiloxane weight-average molecular weight | Organic metal compound | Amount of organic metal compound added [parts by weight] | Sulfide gas resistance | Outcoupling property | Pot life |
| Example 12 | 1-34 | Trifunctional: tetrafunctional= 5:5 | 2000 | Zr chelate | 5 | B | A | B |
| Example 6 | 1-6 | | | | 20 | B | A | B |
| Example 13 | 1-35 | | | | 100 | B | A | B |
| Example 14 | 1-36 | | | Ti alkoxide | 5 | B | B | B |
| Example 15 | 1-37 | | | | 20 | B | B | B |
| Example 16 | 1-38 | | | | 100 | B | C | B |
| Example 17 | 1-39 | | | Alalkoxide | 5 | B | B | B |
| Example 18 | 1-40 | | | | 20 | B | B | B |
| Example 19 | 1-41 | | | | 100 | B | B | B |
| Comparative Example 23 | 1-42 | | | Absence | 0 | D | C | B |
| Comparative Example 24 | 1-43 | | | Zr chelate | 150 | B | B | D |
| Comparative Example 25 | 1-44 | | | Ti alkoxide | 150 | B | D | D |
| Comparative Example 26 | 1-45 | | | Alumina alkoxide | 150 | B | B | D |

EP 2 800 154 A1

As can be clearly seen from Table 2, when the amount of each organic metal compound added was in a range of 5 to 100 parts by weight with respect to 100 parts by weight of polysiloxane (Example 6 and Examples 12 to 19), a sulfide gas resistance was improved.

On the other hand, when the amount of an organic metal compound added was less than 5 parts by weight with respect to 100 parts by weight of polysiloxane (Example 23), the above-described effect was not expressed, and, thus, a sulfide gas resistance was not sufficient. When the amount of an organic metal compound added was more than 100 parts by weight with respect to 100 parts by weight of polysiloxane, a sulfide gas resistance was improved, but a storage property (a pot life) was reduced due to the high reactivity of the organic metal compound.

As the organic metal compound added, in the case of using a Zr chelate that is not absorbed in a wavelength region (wavelength: 420 nm to 485 nm) of a light emitted from the LED element (Examples 6, 12, and 13), outcoupling efficiency was excellent.

Evaluation results for the LED devices according to Examples 6 and 20 to 22 were as shown in Table 3.

[Table 3]

| | LED No. | Sealant | | | | | LED optical property evaluation | Sealant property evaluation |
|---|---|---|---|---|---|---|---|---|
| | | Silane compound polymerization ratio | Polysiloxane weight-average molecular weight | Organic metal compound | Amount of organic metal compound added [parts by weight] | Water [parts by weight] | Moist-heat resistance | Pot life |
| Example 6 | 1-6 | Trifunctional: tetrafunctional= 5:5 | 2000 | Zr chelate | 20 | 0 | C | B |
| Example 20 | 1-46 | | | | | 10 | B | B |
| Example 21 | 1-47 | | | | | 60 | B | B |
| Example 22 | 1-48 | | | | | 120 | B | C |

As can be clearly seen from Table 3, in Examples 20 and 21 in which water was contained in the amount of 10 to 100 parts by weight with respect to 100 parts by weight of polysiloxane, a hydrolysis reaction was carried out before polysiloxane and an organic metal compound were condensed. Therefore, as compared with Example 6 in which water was not contained, a denser film was formed and a moist-heat resistance was improved. On the other hand, in Example 22 in which water was contained in the amount of more than 100 parts by weight with respect to 100 parts by weight of polysiloxane, a hydrolysis reaction caused by water was rapidly carried out and a storage property was decreased.

Evaluation results for the LED devices according to Examples 23 to 30 were as shown in Table 4.

[Table 4]

| | LED No. | Sealant | | | | | | | LED optical property evaluation | Sealant property evaluation |
|---|---|---|---|---|---|---|---|---|---|---|
| | | Silane compound polymerization ratio | Polysiloxane weight-average molecular weight | Organic metal compound | Amount of organic metal compound added [parts by weight] | Water addition amount [parts by weight] | Inorganic fine particle addition | pH | Crack resistance | Pot life |
| Example 23 | 1-49 | Trifunctional: tetrafunctional= 5:5 | 2000 | Zr chelate | 20 | 60 | No | 0.8 | B | C |
| Example 24 | 1-50 | | | | | | | 1 | B | B |
| Example 25 | 1-51 | | | | | | | 4 | B | B |
| Example 26 | 1-52 | | | | | | | 5 | B | C |
| Example 27 | 1-53 | | | | | | Yes | 0.8 | A | C |
| Example 28 | 1-54 | | | | | | | 1 | A | B |
| Example 29 | 1-55 | | | | | | | 4 | A | B |
| Example 30 | 1-56 | | | | | | | 5 | A | C |

EP 2 800 154 A1

41

As can be clearly seen from Table 4, in Examples 27 to 30 in which the sealant for an LED device contained inorganic fine particles, a film strength was improved and crack resistance was improved as compared with Examples 23 to 26 in which the sealant for an LED device did not contain inorganic fine particles.

When a pH of the sealant for an LED device was in a range of 1 to 4 (Examples 24, 25, 28, and 29), a pot life was improved. On the other hand, in Examples 23 and 27 in which a pH of the sealant for an LED device was lower than 1, some gelled materials were generated. Also in Examples 26 and 30 in which a pH of the sealant for an LED device was higher than 4, some gelled materials were generated.

Evaluation results for the LED devices according to Examples 25, 29, and 31 to 34 were as shown in Table 5.

[Table 5]

| | LED No. | Sealant | | | | | | | Film forming condition | Light resistance evaluation |
| | | Silane compound polymerization ratio | Polysiloxane weight-average molecular weight | Organic metal compound | Amount of organic metal compound added [parts by weight] | Water addition amount [parts by weight] | pH | Inorganic fine particle addition | Curing temperature [°C] | |
|---|---|---|---|---|---|---|---|---|---|---|
| Example 31 | 1-57 | Trifunctional: tetrafunctional= 5:5 | 2000 | Zr chelate | 20 | 60 | 4 | No | 80 | C |
| Example 32 | 1-58 | | | | | | | | 100 | B |
| Example 25 | 1-51 | | | | | | | | 150 | B |
| Example 33 | 1-59 | | | | | | | Yes | 80 | C |
| Example 34 | 1-60 | | | | | | | | 100 | B |
| Example 29 | 1-55 | | | | | | | | 150 | B |

As can be clearly seen from Table 5, in Examples 25, 29, 32, and 34 in which a curing temperature of the sealant for an LED device was higher than 100°C, an evaluation result of light resistance was improved. On the other hand, in Examples 31 and 33 in which a curing temperature was lower than 100°C, light resistance was somewhat decreased. This is because organic components such as those generated during hydrolysis of polysiloxane could be removed sufficiently since the film forming temperature of the sealing film was set to higher than 100°C. On the other hand, it is considered that when a film forming temperature was lower than 100°C, the organic components generated during hydrolysis is not sufficiently vaporized and remained in the film, and, thus, light resistance was decreased.

Hereinafter, a method for producing LED devices (LED devices 2-1 to 2-60) having the configuration illustrated in FIG. 2 will be described.

<Production of LED devices 2-1 to 2-60>

LED elements (LED chips) each including package 1 (LED substrate) having a cavity configured as illustrated in FIG. 2 were prepared. To be specific, LED chip-mounting packages were prepared in which a single blue LED chip (rectangular parallelepiped shape: 200 μm x 300 μm x 100 μm) was flip chip-mounted on a central portion of an accommodation part of a circular package (an opening diameter of 3 mm, a bottom surface diameter of 2 mm, and a wall surface angle of 60°). Sealants for LED devices which were the same as LED devices 1-1 to 1-60 were used on the LED chip-mounting packages and sealing layers were formed under the same conditions, so that LED devices 2-1 to 2-60 were obtained.

Hereinafter, a method for producing LED devices (LED devices 3-1 to 3-60) having the configuration illustrated in FIG. 3 will be described.

<Production of LED devices 3-1 to 3-60>

LED elements (LED chips) each including a package (LED substrate) having a cavity configured as illustrated in FIG. 3 were prepared in the same manner as LED devices 2-1 to 2-60. To be specific, there were prepared LED chip-mounting packages in which a single blue LED chip (rectangular parallelepiped shape: 200 μm x 300 μm x 100 μm) was flip chip-mounted on a central portion of an accommodation part of a circular package (an opening diameter of 3 mm, a bottom surface diameter of 2 mm, and a wall surface angle of 60°).

Sealing layers 6 each having a thickness of 1.5 μm were formed using sealing for LED devices which were the same as the LED devices 1-1 to 1-60 except that a phosphor dispersion liquid was not sprayed on the LED chip-mounting packages.

Then, a silicon resin (OE6630, produced by Dow Corning Toray Co., Ltd) in which 10 wt% of a phosphor prepared by the above-described method was dispersed was dropped onto the sealing layers 6 with a dispenser and calcined at 150°C for 1 hour, so that wavelength conversion layers 8 were formed and LED devices 3-1 to 3-60 were produced. The thickness of wavelength conversion layer 8 was set to 2.5 mm.

The LED devices 2-1 to 2-60 and the LED devices 3-1 to 3-60 were also evaluated in the same manner as the LED devices 1-1 to 1-60. The same results as those of the LED devices 1-1 to 1-60 were obtained.

2. Example of second LED device

<Evaluation of adhesion>

The LED devices produced according to Examples and Comparative Examples underwent a thermal shock test using a thermal shock tester (TSA-42EL, manufactured by ESPEC Corp.). The test was carried out by repetitively performing a cycle including: storing the LED devices at -40°C for 30 minutes; and storing the LED devices at 100°C for 30 minutes. After the test, a current was applied to the samples, and lighting thereof was checked. Lighting-off was caused by peeling-off of the light transmissive layer and the wavelength conversion layer.

- lighting is on after 1200 cycles: A
- Although lighting is on after 1,000 cycles, lighting-off occurs before 1,200 cycles: B
- Although lighting is on after 700 cycles, lighting-off occurs before 1,000 cycles: C
- Although lighting is on after 350 cycles, lighting-off occurs before 700 cycles: D

<Evaluation of erosion resistance>

Based on a gas exposure test (JIS C 60068-2-43) according to JIS standard, the produced LED devices were exposed to an atmosphere with a hydrogen sulfide gas of 15 ppm (temperature: 25°C, relative humidity: 75% RH) for 1,000 hours. With respect to each of the LED devices, a total luminous flux was measured before and after exposure, and erosion resistance was evaluated by the following criteria.

- A ratio of total luminous flux to initial luminous flux (the total luminous flux after exposure to the sulfide gas/the total luminous flux before exposure to the sulfide gas x 100) is 96% or more: B
- A ratio of total luminous flux to initial luminous flux (the total luminous flux after exposure to the sulfide gas/the total luminous flux before exposure to the sulfide gas x 100) is 92% or more to less than 96%: C
- A ratio of total luminous flux to initial luminous flux (the total luminous flux after exposure to the sulfide gas/the total luminous flux before exposure to the sulfide gas x 100) is less than 92%: D

<Evaluation of crack resistance>

With respect to each of the LED devices, a light transmissive layer was formed. Then, before a wavelength conversion layer was formed, the outward appearance of the light transmissive layer was observed through a scanning electron microscope (SEM) (VE7800, manufactured by Keyence) at magnification of 1,000 times. With respect to each of them, crack resistance was evaluated by the following criteria.

- The light transmissive layer has no crack having a length of 10 $\mu$m or more: B
- The light transmissive layer has 1 or more to less than 5 cracks having a length of 10 $\mu$m or more: C
- The light transmissive layer has 5 or more cracks having a length of 10 $\mu$m or more: D

<Evaluation of outcoupling property>

The outcoupling property of the produced LED devices was measured using a spectral emission luminance meter (CS-1000, manufactured by KONICA MINOLTA, INC.). According to measurement conditions, a current of 10 mA was applied. Evaluation was made with relative values based on 1.0 as a total luminous flux of an LED device without a light transmissive layer.

- A relative value is 1.1 or more: A
- A relative value is in a range of 1.03 to 1.09: B
- A relative value is in a range of 0.98 to 1.02 : C
- A relative value is 0.97 or less: D

<Evaluation of pot life>

The composition for light transmissive layer was settled at room temperature for 3 weeks. Then, a precipitate was measured with a dynamic light scattering particle size measurement device (Desla nano S, manufactured by Beckman Coulter), and a pot life was evaluated by the following criteria.

- No fine particle is generated in the composition for light transmissive layer: B
- Fine particles or gelled materials having a size of 100 nm or more to 500 nm or less are generated in the composition for light transmissive layer: C
- Particles or gelled materials having a size of more than 500 nm are generated in the composition for light transmissive layer: D

<Evaluation of moist-heat resistance>

The produced LED devices were settled for 1,000 hours at a temperature of 60°C and a relative humidity of 90% RH. With respect to each of the LED devices, a total luminous flux was measured before and after test, and a moist-heat resistance was evaluated by the following criteria.

- A ratio of total luminous flux to initial luminous flux (the total luminous flux after test/the total luminous flux before test x 100) is 96% or more: B
- A ratio of total luminous flux to initial luminous flux (the total luminous flux after test/the total luminous flux before test x 100) is 92% or more to less than 96%: C
- A ratio of total luminous flux to initial luminous flux (the total luminous flux after test/the total luminous flux before test x 100) is less than 92%: D

[Preparation of phosphor particles]

Hereinafter, a method of preparing phosphor particles will be described.

7.41 g of $Y_2O_3$, 4.01 g of $Gd_2O_3$, 0.63 g of $CeO_2$, and 7.77 g of $Al_2O_3$ as phosphor materials were fully mixed. An appropriate amount of ammonium fluoride as flux was mixed therewith, and a crucible made of aluminum was filled with the mixture. The filler was calcined at a temperature in a range of 1350 to 1450°C for 2 to 5 hours under a reducing atmosphere in which a hydrogen-containing nitrogen gas was circulated. As a result, a calcined product $((Y_{0.72}Gd_{0.24})_3Al_5O_{12}:Ce_{0.04})$ was obtained.

The obtained calcined product was ground, cleaned, separated, and dried, so that yellow phosphor particles having an average particle size of about 10 $\mu$m were obtained. When an emission wavelength of an excitation light having a wavelength of 465 nm was measured, a peak wavelength was at about 570 nm.

<Examples>

(Example 1: Production of LED device 1)

36.0 g of tetramethoxysilane, 10.7 g of methyltrimethoxysilane, 9.48 g of dimethoxydimethylsilane, 37.5 g of methanol, and 37.5 g of acetone were mixed with stirring. Then, 51.1 g of water and 4.4 $\mu$L of 60% nitric acid were added thereto with further stirring for 3 hours. Then, the mixture was aged at 26°C for 2 days. The obtained composition was diluted with methanol to a solid value of polysiloxane of 10%. As a result, a polysiloxane solution including polysiloxane having a polymerization ratio of a tetrafunctional component : a trifunctional component : a bifunctional component of 6 : 2 : 2 was obtained. 3.0 g of $ZrO_2$ dispersion liquid (produced by Sakai Chemical Industry Co., Ltd.) in which zirconium oxide ($ZrO_2$) fine particles having an average primary particle size of 5 nm were dispersed was added to 20.0 g of the polysiloxane solution so as to form a composition for light transmissive layer. The concentration of the zirconium oxide was set to 45 wt% with respect to the solid content in the composition for light transmissive layer.

The composition for light transmissive layer was applied on an LED element by spray coating. Thereafter, calcination was carried out at 150°C for 1 hour, and, thus, a light transmissive layer having a thickness of 1.5 $\mu$m was formed. The LED element was an LED chip-mounting package in which a single blue LED chip (rectangular parallelepiped shape: 200 $\mu$m x 300 $\mu$m x 100 $\mu$m) was flip chip-mounted on a central portion of an accommodation part of the circular package (an opening diameter of 3 mm, a bottom surface diameter of 2 mm, and a wall surface angle of 60°).

A silicone resin (OE6630, produced by Dow Corning Toray Co., Ltd) in which 10 wt% of the phosphor was dispersed was applied on the light transmissive layer with a dispenser and calcined at 150°C for 1 hour, so that a wavelength conversion layer was formed. The thickness of the wavelength conversion layer was set to 2.5 mm.

(Example 2: Production of LED device 2)

LED device 2 was produced in the same manner as Example 1 except that instead of a $ZrO_2$ dispersion liquid, there was used 3.0 g of a ZnO dispersion liquid (produced by CIK NanoTek Corporation) in which ZnO fine particles were dispersed. A particle size of the ZnO fine particle was 52 nm, and the concentration of the ZnO fine particles was set to 45 wt% with respect to the solid content in the composition for light transmissive layer.

(Example 3: Production of LED device 3)

LED device 3 was produced in the same manner as Example 1 except that instead of a $ZrO_2$ dispersion liquid, there was used 3.0 g of a $SiO_2$ dispersion liquid (produced by CIK NanoTek Corporation) in which $SiO_2$ fine particles were dispersed. A particle size of the $SiO_2$ fine particle was 30 nm, and the concentration of the $SiO_2$ fine particles was set to 45 wt% with respect to the solid content in the composition for light transmissive layer.

(Comparative Example 1: Production of LED device 4)

LED device 4 was produced in the same manner as Example 1 except that a $ZrO_2$ dispersion liquid was not added.

(Comparative Example 2: Production of LED device 5)

LED device 5 was produced in the same manner as Example 1 except that a light transmissive layer was not formed.

Evaluation results for the LED devices according to Examples 1 to 3 and Comparative Examples 1 and 2 were as shown in Table 6.

[Table 6]

| | LED Device | Polysiloxane Polymerization ratio (tetrafunctional: trifunctional: bifunctional) | Metal oxide fine particle Kind | Evaluation Adhesion | Outcoupling property | Erosion resistance | Crack resistance |
|---|---|---|---|---|---|---|---|
| Example 1 | 1 | 6:2:2 | $ZrO_2$ | B | A | B | B |
| Example 2 | 2 | | ZnO | B | B | B | B |
| Example 3 | 3 | | $SiO_2$ | B | C | B | B |
| Comparative Example 1 | 4 | | - | D | D | C | D |
| Comparative Example 2 | 5 | No light transmissive layer | | B | D | D | - |

As can be clearly seen from Table 6, in the case of adding the metal oxide fine particles to the light transmissive layer (Examples 1 to 3), adhesion between the wavelength conversion layer and the light transmissive layer was improved. This is because an irregularity was formed on a surface of the light transmissive layer due to the metal oxide fine particles contained in the light transmissive layer, and, thus, an anchor effect was expressed. It is considered that by the irregularity, wettability of the composition for forming the wavelength conversion layer was improved and adhesion was further improved.

In the case of adding the metal oxide fine particles to the light transmissive layer (Examples 1 to 3), crack resistance was excellent. It is assumed that this is because a stress generated during formation of the light transmissive layer was relieved by the metal oxide fine particles. In Examples 1 to 3, since the crack resistance was excellent, erosion resistance was also improved.

In this regard, in the case where the metal oxide fine particles were not added to the light transmissive layer (Comparative Example 1), adhesion of the wavelength conversion layer was low and the light transmissive layer was cracked, and, thus, erosion resistance was also low.

In the case where the light transmissive layer was not formed (Comparative Example 2), a refractive index was not gradually varied from the LED element to the wavelength conversion layer, and, thus, outcoupling property was low. There was no barrier property, and, thus, erosion resistance was also very low.

In the case of adding zirconium oxide having a high refractive index to the light transmissive layer, the outcoupling property was remarkably improved (Example 1). It is assumed that this is because due to addition of the zirconium oxide having a high refractive index, a refractive index of the light transmissive layer becomes between a refractive index of a surface of the LED chip and a refractive index of the wavelength conversion layer, reflection at interfaces between the respective layers is greatly decreased.

(Example 4: Production of LED device 6)

LED device 6 was produced in the same manner as Example 1 except that a $ZrO_2$ dispersion liquid was added such that the concentration of $ZrO_2$ fine particles was 5 wt% with respect to the solid content in a composition for light transmissive layer.

(Example 5: Production of LED device 7)

LED device 7 was produced in the same manner as Example 1 except that a $ZrO_2$ dispersion liquid was added such that the concentration of $ZrO_2$ fine particles was 10 wt% with respect to the solid content in a composition for light transmissive layer.

(Example 6: Production of LED device 8)

LED device 8 was produced in the same manner as Example 1 except that a ZrO$_2$ dispersion liquid was added such that the concentration of ZrO$_2$ fine particles was 30 wt% with respect to the solid content in a composition for light transmissive layer.

(Example 7: Production of LED device 9)

LED device 9 was produced in the same manner as LED device 1 except that a ZrO$_2$ dispersion liquid was added such that the concentration of ZrO$_2$ fine particles was 60 wt% with respect to the solid content in a composition for light transmissive layer.

(Example 8: Production of LED device 10)

LED device 10 was produced in the same manner as LED device 1 except that a ZrO$_2$ dispersion liquid was added such that the concentration of ZrO$_2$ fine particles was 80 wt% with respect to the solid content in a composition for light transmissive layer.

(Comparative Example 3: Production of LED device 11)

LED device 11 was produced in the same manner as LED device 1 except that a polysiloxane solution was NN120-20 (perhydropolysilazane of 20 wt% and xylene of 80 wt%, produced by AZ Electronic Materials), and the concentration of ZrO$_2$ fine particles was 10 wt% with respect to the solid content in a composition for light transmissive layer.

Evaluation results for the LED devices according to Examples 4 to 8 and Comparative Examples 1 and 3 were as shown in Table 7.

[Table 7]

| | LED device | Polysiloxane | Metal oxide fine particle | | Evaluation | | | | |
|---|---|---|---|---|---|---|---|---|---|
| | | Polymerization ratio (tetrafunctional: trifunctional: bifunctional) | Kind | Concentration [wt %] | Adhesion | Outcoupling property | Erosion resistance | Crack resistance | Pot life |
| Comparative Example 1 | 4 | 6:2:2 | ZrO$_2$ | 0 | D | D | C | D | B |
| Example 4 | 6 | | | 5 | C | C | B | B | B |
| Example 5 | 7 | | | 10 | B | B | B | B | B |
| Example 6 | 8 | | | 30 | B | B | B | B | B |
| Example 7 | 9 | | | 60 | B | B | B | B | B |
| Example 8 | 10 | | | 80 | B | C | C | C | B |
| Comparative Example 3 | 11 | Polysilazane | | 10 | B | C | B | B | D |

It can be seen from Table 7 above that as the concentration of the metal oxide fine particles (zirconium oxide) was increased, adhesion was improved and crack resistance or erosion resistance and outcoupling property were also improved. However, when the amount of the metal oxide fine particles was 80 wt% or more with respect to the solid content in the composition for light transmissive layer (Example 8), a light transmittance of the light transmissive layer was decreased. It is assumed that this is because since the metal oxide fine particles were excessively contained, transparency of the light transmissive layer was reduced due to presence of the metal oxide fine particles. When the metal oxide fine particles were excessively contained, the amount of polysiloxane was relatively decreased and crack resistance or erosion resistance was also decreased.

Even when the metal oxide fine particles were added, in the case where a binder was formed of polysilazane (Comparative Example 3), a pot life was reduced and an effect of outcoupling property improvement was low. It is assumed that this is because the composition for light transmissive layer containing polysilazane had a low stability and gelled materials or the like were generated in the composition for light transmissive layer.

(Example 9: Production of LED device 12)

LED device 12 was produced in the same manner as Example 1 except that there was used a zirconium oxide dispersion liquid (produced by Sakai Chemical Industry Co., Ltd.) in which zirconium oxide ($ZrO_2$) having an average primary particle size of 5 nm was dispersed and the concentration of zirconium oxide fine particles was set to 30 wt% with respect to the solid content in the composition for light transmissive layer.

(Example 10: Production of LED device 13)

LED device 13 was produced in the same manner as Example 1 except that there was used a zirconium oxide ($ZrO_2$) dispersion liquid (produced by TECNAN) in which zirconium oxide ($ZrO_2$) having an average primary particle size of 10 nm was dispersed and the concentration of zirconium oxide fine particles was set to 30 wt% with respect to the solid content in the composition for light transmissive layer.

(Example 11: Production of LED device 14)

LED device 14 was produced in the same manner as Example 1 except that there was used a zirconium oxide ($ZrO_2$) dispersion liquid (produced by CIK NanoTek Corporation) in which zirconium oxide ($ZrO_2$) having an average primary particle size of 20 nm was dispersed and the concentration of zirconium oxide fine particles was set to 30 wt% with respect to the solid content in the composition for light transmissive layer.

(Example 12: Production of LED device 15)

LED device 15 was produced in the same manner as Example 1 except that there was used a zirconium oxide ($ZrO_2$) dispersion liquid (produced by CIK NanoTek Corporation) in which zirconium oxide ($ZrO_2$) having an average primary particle size of 50 nm was dispersed and the concentration of zirconium oxide fine particles was set to 30 wt% with respect to the solid content in the composition for light transmissive layer.

(Example 13: Production of LED device 16)

LED device 16 was produced in the same manner as Example 1 except that there was used a zirconium oxide ($ZrO_2$) dispersion liquid (produced by CIK NanoTek Corporation) in which zirconium oxide ($ZrO_2$) having an average primary particle size of 200 nm was dispersed and the concentration of zirconium oxide fine particles was set to 30 wt% with respect to the solid content in the composition for light transmissive layer.

Evaluation results for the LED devices according to Examples 9 to 13 were as shown in Table 8.

[Table 8]

| | LED device | Polysiloxane Polymerization ratio (tetrafunctional: trifunctional: bifunctional) | Metal oxide fine particle Concentration [wt %] | Kind | Particle size [nm] | Evaluation Adhesion | Outcoupling property | Pot life |
|---|---|---|---|---|---|---|---|---|
| Example 9 | 12 | | | | 5 | B | B | B |
| Example 10 | 13 | | | | 10 | B | B | B |
| Example 11 | 14 | 6:2:2 | 30wt% | ZrO$_2$ | 20 | B | B | B |
| Example 12 | 15 | | | | 50 | B | B | B |
| Example 13 | 16 | | | | 200 | B | C | C |

It can be seen from Table 8 above that in the case where the metal oxide fine particles had an average primary particle size of 50 nm or less (Examples 9 to 12), the above-described anchor effect or effect of outcoupling property improvement was observed and also a pot life was excellent. Meanwhile, when an average primary particle size of the metal oxide fine particles was increased, a pot life was decreased (Example 13). It is assumed that this is because when an average primary particle size of the metal oxide fine particles was increased, the metal oxide fine particles in the composition for light transmissive layer were settled. Since an average primary particle size of the metal oxide fine particles was increased, outcoupling efficiency was decreased. It is assumed that this is because transparency of the light transmissive layer was reduced due to presence of the metal oxide fine particles having a large average primary particle size.

(Example 14: Production of LED device 17)

LED device 17 was produced in the same manner as Example 1 except that 47.3 g of methyltrimethoxysilane, 13.1 g of tetramethoxysilane, 40.0 g of methanol, and 40.0 g of acetone were mixed with stirring in the same order of producing LED device 1. Then, 54.6 g of water and 4.7 μL of 60% nitric acid were added thereto with further stirring for 3 hours. The obtained composition was diluted with methanol to a solid value of polysiloxane of 10%. As a result, a polysiloxane solution including polysiloxane having a polymerization ratio of a trifunctional component : a tetrafunctional component of 2 : 8 was obtained. A zirconium oxide (ZrO$_2$) dispersion liquid (produced by Sakai Chemical Industry Co., Ltd.) in which zirconium oxide (ZrO$_2$) having an average primary particle size of 5 nm was dispersed was added to the polysiloxane solution such that the concentration of the zirconium oxide was 30 wt% with respect to the solid content in the composition for light transmissive layer.

(Example 15: Production of LED device 18)

LED device 18 was produced in the same manner as Example 14 except that methyltrimethoxysilane was added in the amount of 17.7 g and tetramethoxysilane was added in the amount of 46.1 g.

(Example 16: Production of LED device 19)

LED device 19 was produced in the same manner as Example 14 except that methyltrimethoxysilane was added in the amount of 29.4 g and tetramethoxysilane was added in the amount of 32.9 g.

(Example 17: Production of LED device 20)

LED device 20 was produced in the same manner as Example 14 except that methyltrimethoxysilane was added in the amount of 41.3 g and tetramethoxysilane was added in the amount of 19.8 g.

(Example 18: Production of LED device 21)

LED device 21 was produced in the same manner as Example 14 except that methyltrimethoxysilane was added in the amount of 47.3 g and tetramethoxysilane was added in the amount of 13.1 g.

(Comparative Example 4: Production of LED device 22)

LED device 22 was produced in the same manner as Example 14 except that tetramethoxysilane was not added and methyltrimethoxysilane was added in the amount of 59.0 g.

(Example 19: Production of LED device 23)

LED device 23 was produced in the same manner as Example 14 except that methyltrimethoxysilane was not added and tetramethoxysilane was added in the amount of 65.9 g.

(Comparative Example 5: Production of LED device 24)

LED device 24 was produced in the same manner as Example 14 except that tetramethoxysilane was not added, and methyltrimethoxysilane was added in the amount of 29.4 g and dimethoxydimethylsilane was added in the amount of 26.0 g.

Evaluation results for the LED devices according to Examples 14 to 19 and Comparative Examples 4 and 5 were as shown in Table 9.

[Table 9]

| | LED Device | Polysiloxane | Metal oxide fine particle | Evaluation | | |
| --- | --- | --- | --- | --- | --- | --- |
| | | Polymerization ratio | Kind/ concentration [wt %]/ particle size [nm] | Adhesion | Erosion resistance | Crack resistance |
| Example 14 | 17 | Trifunctional: tetrafunctional=2:8 | ZrO$_2$/30wt%/5nm | B | C | C |
| Example 15 | 18 | Trifunctional: tetrafunctional=3:7 | | B | B | B |
| Example 16 | 19 | Trifunctional: tetrafunctional=5:5 | | B | B | B |
| Example 17 | 20 | Trifunctional: tetrafunctional=7:3 | | B | B | B |
| Example 18 | 21 | Trifunctional: tetrafunctional=8:2 | | C | B | B |
| Comparative Example 4 | 22 | Only trifucntional | | D | B | B |
| Example 19 | 23 | Only tetrafunctional | | B | C | C |
| Comparative Example 5 | 24 | Bifunctional: trifunctional=5:5 | | D | B | B |

It can be seen from Table 9 above that in the case where polysiloxane formed by polymerization of monomers including a tetrafunctional silane compound was added as a composition for light transmissive layer (Examples 14 to 19), adhesion between the light transmissive layer and the wavelength conversion layer was improved. In the case where polysiloxane formed by polymerization of a tetrafunctional silane compound and a trifunctional silane compound at a polymerization molar ratio of 3:7 to 7:3 was added (Examples 15 to 17), erosion resistance or crack resistance was very excellent. On the other hand, when a polymerization molar ratio of the tetrafunctional silane compound was greater than the above-described range, during formation of the light transmissive layer, the light transmissive layer was greatly contracted and was likely to be partially cracked (Examples 14 and 19). In particular, when a polymerization molar ratio of the tetrafunctional silane compound was smaller than the above-described range, adhesion between the light transmissive layer and the wavelength conversion layer was likely to decrease (Example 18).

In the case where polysiloxane formed by polymerization of monomers including a bifunctional silane compound and a trifunctional silane compound without a tetrafunctional silane compound, or polysiloxane formed by polymerization of monomers including a trifunctional silane compound only was added, adhesion between the light transmissive layer and the wavelength conversion layer was decreased (Comparative Examples 4 and 5). It is assumed that this is because the amount of organic groups remaining in the polysiloxane molecular chain was increased, and, thus, a wettability of a composition for forming the wavelength conversion layer was decreased.

(Example 20: Production of LED device 25)

LED device 25 was produced in the same manner as Example 15 except that, in the composition for light transmissive layer, acetylacetone (produced by Kanto Chemical Co., Inc.) as a stabilizer was added in the amount of 10 wt% with respect to the total amount of the composition for light transmissive layer and ZC-580 (produced by Matsumoto Fine Chemical Co., Ltd.) as a Zr chelate was added such that the amount of the solid content thereof was 10 wt% with respect to the solid content in the composition for light transmissive layer.

(Example 21: Production of LED device 26)

LED device 26 was produced in the same manner as Example 20 except that a Zr chelate was not added and ALR15GB (produced by Kojundo Chemical Lab. Co., Ltd.) as an Al alkoxide was added such that the amount of the solid content thereof was 10 wt% with respect to the solid content in the composition for light transmissive layer.

(Example 22: Production of LED device 27)

LED device 27 was produced in the same manner as Example 20 except that a Zr chelate was not added and TA25 (produced by Matsumoto Fine Chemical Co., Ltd.) as a Ti alkoxide was added such that the amount of the solid content thereof was 10 wt% with respect to the solid content in the composition for light transmissive layer.

Evaluation results for the LED devices according to Examples 15 and 20 to 22 were as shown in Table 10.

[Table 10]

| | LED device | Polysiloxane | Metal oxide fine particle | Metal alkoxide or metal chelate | Evaluation | | |
|---|---|---|---|---|---|---|---|
| | | Polymerization ratio(Trifunctional: tetrafunctional) | Kind/ concentration [wt %]/ particle size [nm] | | Adhesion | Outcoupling property | Pot life |
| Example 20 | 25 | 3:7 | $ZrO_2$/30wt%/5nm | Zr chelate | A | A | B |
| Example 21 | 26 | | | Al alkoxide | A | B | C |
| Example 22 | 27 | | | Ti alkoxide | A | C | C |
| Example 15 | 18 | | | Absence | B | B | B |

It can be seen from Table 10 above that in the case where a metal alkoxide or a metal chelate was contained as a composition for light transmissive layer, adhesion between the light transmissive layer and the wavelength conversion layer was very improved (Examples 20 to 22). It is considered that Zr, Al, and Ti have a higher reactivity than Si in the polysiloxane, and these metals formed a strong and firm metal-oxane bonding with a hydroxyl group or the like present in the polysiloxane or in a surface of the wavelength conversion layer, and, thus, such an improved adhesion was obtained. However, Al alkoxide or Ti alkoxide reacted during storage due to the high reactivity thereof, and, thus, a pot life was likely to decrease (Examples 21 and 22).

(Example 23: Production of LED device 28)

LED device 28 was produced in the same manner as Example 20 except that pure water was added in the amount of 3 wt% with respect to the total amount of a polysiloxane solution.

(Example 24: Production of LED device 29)

LED device 29 was produced in the same manner as Example 20 except that pure water was added in the amount of 10 wt% with respect to the total amount of a polysiloxane solution.

(Example 25: Production of LED device 30)

LED device 30 was produced in the same manner as Example 20 except that pure water was added in the amount of 15 wt% with respect to the total amount of a polysiloxane solution.

(Example 26: Production of LED device 31)

LED device 31 was produced in the same manner as Example 20 except that pure water was added in the amount of 25 wt% with respect to the total amount of a polysiloxane solution.

Evaluation results for the LED devices according to Examples 20 and 23 to 26 were as shown in Table 11.

[Table 11]

| | LED device | Polysiloxane | Metal oxide fine particle | Metal alkoxide or metal chelate | Water addition concentration [wt %] | Evaluation | |
|---|---|---|---|---|---|---|---|
| | | Polymerization ratio (Trifunctional: tetrafunctional) | Kind/ concentration [wt %]/ particle size [nm] | | | Moist-heat resistance | Pot life |
| Example 20 | 25 | 3:7 | $ZrO_2$/30wt%/5nm | Zr chelate | 0 | C | B |
| Example 23 | 28 | | | | 3 | B | B |
| Example 24 | 29 | | | | 10 | B | B |
| Example 25 | 30 | | | | 15 | B | B |
| Example 26 | 31 | | | | 25 | B | C |

As can be clearly seen from Table 11, in the case where water was contained in the amount of 3 to 25 wt% in the composition for light transmissive layer, polysiloxane underwent a hydrolysis reaction before being condensed and a dense film was formed. Thus, a good moist-heat resistance was obtained (Examples 23 to 26) as compared with the case where water was not added (Example 20). On the other hand, in the case where water was contained in the amount of more than 25 wt% in the composition for light transmissive layer, a hydrolysis reaction caused by water was rapidly carried out and a storage property was decreased (Example 26).

3. Example of third LED device

<Evaluation of adhesion>

The LED devices produced according to Examples and Comparative Examples underwent a thermal shock test using a thermal shock tester (TSA-42EL, manufactured by ESPEC Corp.). The test was carried out by repetitively performing a cycle including: storing the LED devices at -40°C for 30 minutes; and storing the LED devices at 100°C for 30 minutes. After the test, a current was applied to the samples, and lighting thereof was checked. Lighting-off was caused by peeling-off at an interface between the LED chip and the light transmissive layer, or at an interface between the primer layer and the light transmissive layer.

- Lighting is on after 1,200 cycles: A
- Although lighting is on after 1,000 cycles, lighting-off occurs before 1,200 cycles: B
- Although lighting is on after 700 cycles, lighting-off occurs before 1,000 cycles: C
- Although lighting is on after 350 cycles, lighting-off occurs before 700 cycles: D

<Evaluation of erosion resistance>

Based on a gas exposure test (JIS C 60068-2-43) according to JIS standard, the produced LED devices were exposed to an atmosphere with a hydrogen sulfide gas of 15 ppm (temperature: 25°C, relative humidity: 75% RH) for 1,000 hours. With respect to each of the LED devices, a total luminous flux was measured before and after exposure, and erosion resistance was evaluated by the following criteria.

- A ratio of total luminous flux to initial luminous flux (the total luminous flux after exposure to the sulfide gas/the total luminous flux before exposure to the sulfide gas x 100) is 98% or more: A
- A ratio of total luminous flux to initial luminous flux (the total luminous flux after exposure to the sulfide gas/the total luminous flux before exposure to the sulfide gas x 100) is 96% or more to less than 98%: B
- A ratio of total luminous flux to initial luminous flux (the total luminous flux after exposure to the sulfide gas/the total luminous flux before exposure to the sulfide gas x 100) is 92% or more to less than 96%: C
- A ratio of total luminous flux to initial luminous flux (the total luminous flux after exposure to the sulfide gas/the total luminous flux before exposure to the sulfide gas x 100) is less than 92%: D

<Evaluation of crack resistance>

In each of Examples or Comparative Examples, a light transmissive layer was formed, and then, before a wavelength conversion layer was formed, the outward appearance of the light transmissive layer was observed through a scanning electron microscope (SEM) (VE7800, manufactured by Keyence) at magnification of 1,000 times. With respect to each of them, crack resistance was evaluated by the following criteria.

- The light transmissive layer has no crack having a length of 5 $\mu$m or more: A
- The light transmissive layer has no crack having a length of 10 $\mu$m or more: B
- The light transmissive layer has 1 or more to less than 5 cracks having a length of 10 $\mu$m or more: C
- The light transmissive layer has 5 or more cracks having a length of 10 $\mu$m or more: D

<Evaluation of light resistance>

The composition for primer layer was applied on a slide glass and dried at 70°C for 30 minutes. In this case, the thickness of a primer layer after drying was 1 $\mu$m, and the amount of a metal element derived from an organic metal monomer present in a surface of the primer layer was set to 30 at.% with respect to all elements present in the surface of the primer layer. With respect to the slide glass, a light transmittance before and after a test with 150 mW for 100 hours using a metal halide lamp light resistance tester (M6T, manufactured by SUGA TEST INSTRUMENTS CO., LTD.) was measured, and light resistance was evaluated by the following criteria.

- A decrease in average transmittance of the treated sample at 300 nm to 500 nm is less than 1.0%: B

- A decrease in average transmittance of the treated sample at 300 nm to 500 nm is 1.0% or more to less than 1.5%: C

- A decrease in average transmittance of the treated sample at 300 nm to 500 nm is 1.5% or more: D

<Evaluation of pot life>

The composition for light transmissive layer was settled at room temperature for 3 weeks. Then, a precipitate was measured with a dynamic light scattering particle size measurement device (Desla nano S, manufactured by Beckman Coulter), and a pot life was evaluated by the following criteria.

- No fine particle is generated in the composition for light transmissive layer: B

- Fine particles or gelled materials having a size of 100 nm or more to 500 nm or less are generated in the composition for light transmissive layer: C
- Particles or gelled materials having a size of more than 500 nm are generated in the composition for light transmissive layer: D

<Evaluation of moist-heat resistance>

The produced LED devices were settled for 1,000 hours at a temperature of 60°C and a relative humidity of 90% RH. With respect to each of the LED devices, a total luminous flux was measured before and after test, and a moist-heat resistance was evaluated by the following criteria.

- A ratio of total luminous flux to initial luminous flux (the total luminous flux after test/the total luminous flux before test x 100) is 96% or more: B
- A ratio of total luminous flux to initial luminous flux (the total luminous flux after test/the total luminous flux before test x 100) is 92% or more to less than 96%: C
- A ratio of total luminous flux to initial luminous flux (the total luminous flux after test/the total luminous flux before test x 100) is less than 92%: D

<Evaluation of outcoupling property>

The outcoupling property of the produced LED devices was measured using a spectral emission luminance meter (CS-1000, manufactured by KONICA MINOLTA, INC.). According to measurement conditions, a current of 10 mA was applied. Evaluation was made with relative values based on 1.0 as a total luminous flux of an LED device without a primer layer.

- A relative value is 1.1 or more: A
- A relative value is in a range of 1.03 to 1.09: B
- A relative value is in a range of 0.98 to 1.02: C
- A relative value is 0.97 or less: D

<Example>

(Example 1: Production of LED device 1)

• Preparation of composition for primer layer

0.5 g of Al alkoxide (ALR15GB, produced by Kojundo Chemical Lab. Co., Ltd.), 0.5 g of a stabilizer (acetylacetone), and 4.0 g of 2-propanol were mixed with stirring so as to prepare a composition for primer layer.

Preparation of composition for light transmissive layer

36.0 g of tetramethoxysilane, 10.7 g of methyltrimethoxysilane, 9.48 g of dimethoxydimethylsilane, 37.5 g of methanol, and 37.5 g of acetone were mixed with stirring. 51.1 g of water and 4.4 $\mu$L of 60% nitric acid were added thereto with further stirring for 3 hours. Then, the solution was aged at 26°C for 2 days. The obtained composition was diluted with methanol so that the solid content of polysiloxane was 10 wt% so as to form a composition for light transmissive layer. In the composition for light transmissive layer, polysiloxane was a compound formed by polymerization of a tetrafunctional silane compound, a trifunctional silane compound, and a bifunctional silane compound at a polymerization ratio of 6:2:2.

Preparation of phosphor particles

Hereinafter, a method of preparing phosphor particles will be described. 7.41 g of $Y_2O_3$, 4.01 g of $Gd_2O_3$, 0.63 g of $CeO_2$, and 7.77 g of $Al_2O_3$ as phosphor materials were fully mixed. An appropriate amount of ammonium fluoride as flux was mixed therewith, and a crucible made of aluminum was filled with the mixture. The filler was calcined at a temperature in a range of 1350 to 1450°C for 2 to 5 hours under a reducing atmosphere in which a hydrogen-containing nitrogen gas was circulated. As a result, a calcined product $((Y_{0.72}Gd_{0.24})_3Al_5O_{12}:Ce_{0.04})$ was obtained.
The obtained calcined product was ground, cleaned, separated, and dried, so that yellow phosphor particles having an average particle size of about 10 $\mu$m were obtained. When an emission wavelength of an excitation light having a wavelength of 465 nm was measured, a peak wavelength was at about 570 nm.

Production of LED device

An LED element was prepared, and a composition for primer layer was applied by spray coaitng so as to cover an LED chip and a metal part of the LED element, and then, dried at 70°C for 30 minutes so as to form a primer layer. The thickness of the primer layer was set to 0.1 $\mu$m, and the amount of a metal element derived from an organic metal monomer present in a surface of the primer layer was set to 30 at.% with respect to all elements present in the surface of the primer layer. The LED element was an LED chip-mounting package in which a single blue LED chip (rectangular parallelepiped shape: 200 $\mu$m x 300 $\mu$m x 100 $\mu$m) was flip chip-mounted on a central portion of an accommodation part of the circular package (an opening diameter of 3 mm, a bottom surface diameter of 2 mm, and a wall surface angle of 60°).

A composition for light transmissive layer was applied on the primer layer by spray coating and calcined at 150°C for 1 so as to form a light transmissive layer. The thickness of the light transmissive layer was set to 1.5 $\mu$m.

A silicon resin (OE6630, produced by Dow Corning Toray Co., Ltd.) in which 10 wt% of phosphor particles were dispersed was applied on the light transmissive layer with a dispenser, and then, calcined at 150°C for 1 hour so as to form a wavelength conversion layer. The thickness of the wavelength conversion layer was set to 2.5 mm.

(Example 2: Production of LED device 2)

LED device 2 was produced in the same manner as Example 1 except that 0.5 g of Si alkoxide (dimethoxydimethylsilane (D1052, produced by TOKYO KASEI KOGYO CO., LTD.)) and 4.5 g of 2-propanol were mixed with stirring so as to prepare a composition for primer layer.

(Example 3: Production of LED device 3)

LED device 3 was produced in the same manner as Example 1 except that 0.71 g of Ti chelate (titanium acetylacetonate (TC-100, produced by Matsumoto Fine Chemical Co., Ltd.)), 0.5 g of a stabilizer (acetylacetone), and 3.8 g of 2-propanol were mixed with stirring so as to prepare a composition for primer layer.

(Example 4: Production of LED device 4)

LED device 4 was produced in the same manner as Example 1 except that 0.71 g of Zr chelate (dibutoxy zirconium bis (ethyl acetoacetate) (ZC-580, produced by Matsumoto Fine Chemical Co., Ltd.)), 0.5 g of a stabilizer (acetylacetone), and 3.8 g of 2-propanol were mixed with stirring so as to prepare a composition for primer layer.

(Example 5: Production of LED device 5)

LED device 5 was produced in the same manner as Example 1 except that 0.25 g of Si alkoxide (dimethoxydimethylsilane (D1052, produced by TOKYO KASEI KOGYO CO., LTD.)), 0.36 g of Ti chelate (titanium acetylacetonate (TC-100, produced by Matsumoto Fine Chemical Co., Ltd.)), 0.5 g of a stabilizer (acetylacetone), and 3.89 g of 2-propanol were mixed with stirring so as to prepare a composition for primer layer.

(Example 6: Production of LED device 6)

LED device 6 was produced in the same manner as Example 1 except that 0.25 g of Si alkoxide (dimethoxydimethylsilane (D1052, produced by TOKYO KASEI KOGYO CO., LTD.)), 0.36 g of Zr chelate (dibutoxy zirconium bis (ethyl acetoacetate) (ZC-580, produced by Matsumoto Fine Chemical Co., Ltd.)), 0.5 g of a stabilizer (acetylacetone), and 3.89 g of 2-propanol were mixed with stirring so as to prepare a composition for primer layer.

(Comparative Example 1: Production of LED device 7)

LED device 7 was produced in the same manner as Example 1 except that a primer layer was not formed.

Evaluation results for the LED devices according to Examples 1 to 6 and Comparative Example 1 were as shown in Table 12.

[Table 12]

| | LED device | Primer layer | Light transmissive layer | Evaluation | | |
| --- | --- | --- | --- | --- | --- | --- |
| | | Organic metal monomer | Polysiloxane polymerization ratio | Adhesion | Erosion resistance | Outcoupling property |
| Example 1 | 1 | Al alkoxide | Tetrafunctional: trifunctional: bifunctional=6:2:2 | B | B | C |
| Example 2 | 2 | Si alkoxide | | B | B | B |
| Example 3 | 3 | Ti chelate | | B | B | A |
| Example 4 | 4 | Zr chelate | | B | B | A |
| Example 5 | 5 | Si alkoxide+Ti chelate | | B | B | A |
| Example 6 | 6 | Si alkoxide+Zr chelate | | B | B | A |
| Comparative Example 1 | 7 | Absence | | D | D | - |

As shown in Table 12 above, when the primer layer was formed, adhesion between the LED element and the light transmissive layer was improved (Examples 1 to 6) as compared with the case where a primer layer was not formed (Comparative Example 1). It is assumed that this is because a metal in the primer layer formed strong metal-oxane bonds with hydroxyl groups present on the surface of the LED element or polysiloxane in the light transmissive layer. In the case where Si alkoxide, Ti chelate, and Zr chelate were added to the composition for primer layer (Examples 2 to 6), the outcoupling property thereof was improved, and particularly, in the case where Ti chelate and Zr chelate were added (Examples 3 to 6), the outcoupling property was particularly excellent. Ti or Zr does not have an adsorption wavelength in an emission wavelength region (particularly, a blue light (wavelength: 420 nm to 485 nm)) of the LED chip. Therefore, it is assumed that the light transmissive layer containing a zirconium-based metal element did not absorb but transmitted a light irradiated from the LED element. It is assumed that the reason why outcoupling property was reduced in the case where a primer layer was not formed is because adhesion between the light transmissive layer and the LED chip was low and peeling-off occurred at an interface therebetween.

(Example 7: Production of LED device 8)

LED device 8 was produced in the same manner as Example 1 except that 0.59 g of tetrafunctional Zr alkoxide (tetranormalbutoxy zirconium (ZA-65, produced by Matsumoto Fine Chemical Co., Ltd.)), 0.5 g of a stabilizer (acetylacetone), and 3.9 g of 2-propanol were mixed with stirring so as to prepare a composition for primer layer.

(Example 8: Production of LED device 9)

LED device 9 was produced in the same manner as Example 1 except that 0.3 g of tetrafunctional Zr alkoxide (tetranormalbutoxy zirconium (ZA-65, produced by Matsumoto Fine Chemical Co., Ltd.)), 0.56 g of trifunctional Zr chelate (zirconium tributoxy monoacetyl acetoacetate (ZC-540, produced by Matsumoto Fine Chemical Co., Ltd.), 0.5 g of a stabilizer (acetylacetone), and 7.24 g of 2-propanol were mixed with stirring so as to prepare a composition for primer layer.

(Example 9: Production of LED device 10)

LED device 10 was produced in the same manner as Example 1 except that 1.1 g of trifunctional Zr chelate (zirconium tributoxy monoacetyl acetoacetate (ZC-540, produced by Matsumoto Fine Chemical Co., Ltd.), 0.9 g of a stabilizer (acetylacetone), and 9.1 g of 2-propanol were mixed with stirring so as to prepare a composition for primer layer.

Evaluation results for the LED devices according to Examples 4 and 7 to 9 were as shown in Table 13.

[Table 13]

| | LED device | Primer layer | | Light transmissive layer | Evaluation | | |
|---|---|---|---|---|---|---|---|
| | | Kind of organic metal monomer | Reactive functional group | Polysiloxane polymerization ratio | Adhesion | Erosion resistance | Light resistance |
| Example 4 | 4 | Zr chelate | Only bifunctional | Tetrafunctional: trifunctional: bifunctional=6:2:2 | B | B | C |
| Example 7 | 8 | Zr alkoxide | Only tetrafunctional | | A | B | B |
| Example 8 | 9 | Zr alkoxide+Zr chelate | Tetrafunctional + trifunctional | | A | B | B |
| Example 9 | 10 | Zr chelate | Only trifucntional | | A | B | B |

EP 2 800 154 A1

As shown in Table 13 above, when the number of reactive functional groups of the organic metal monomer in the primer layer was 3 or 4, adhesion was improved (Examples 7 to 9) as compared with the case where the number of reactive functional groups was 2 (Example 4). This is because a dense metal-oxane bonding was formed due to the increased number of reactive functional groups. When the number of reactive functional groups of the organic metal monomer was 3 or 4, light resistance was also improved. This is because when a monomer had more reactive functional groups, the amount of organic components remaining in a formation was small and deterioration (coloring) caused by light became less.

(Example 10: Production of LED device 11)

47.3 g of methyltrimethoxysilane, 13.1 g of tetramethoxysilane, 40.0 g of methanol, and 40.0 g of acetone were mixed with stirring. Then, 54.6 g of water and 4.7 μL of 60% nitric acid were added thereto with further stirring for 3 hours. The obtained composition was diluted with methanol to a solid value of polysiloxane of 10% so as to form a composition for light transmissive layer. In the composition for light transmissive layer, polysiloxane was a compound formed by polymerization of a trifunctional silane compound and a tetrafunctional silane compound at a ratio of 2:8.
LED device 11 was produced in the same manner as Example 7 except that a light transmissive layer was formed of the composition for light transmissive layer.

(Example 11: Production of LED device 12)

LED device 12 was produced in the same manner as Example 10 except that the amount of methyltrimethoxysilane was 17.7 g and the amount of tetramethoxysilane was 46.1 g.

(Example 12: Production of LED device 13)

LED device 13 was produced in the same manner as Example 10 except that the amount of methyltrimethoxysilane was 29.4 g and the amount of tetramethoxysilane was 32.9 g.

(Example 13: Production of LED device 14)

LED device 14 was produced in the same manner as Example 10 except that the amount of methyltrimethoxysilane was 41.3 g and the amount of tetramethoxysilane was 19.8 g.

(Example 14: Production of LED device 15)

LED device 15 was produced in the same manner as Example 10 except that the amount of methyltrimethoxysilane was 47.3 g and the amount of tetramethoxysilane was 13.1 g.

(Comparative Example 2: Production of LED device 16)

LED device 16 was produced in the same manner as Example 10 except that tetramethoxysilane was not added and the amount of methyltrimethoxysilane was 59.0 g.

(Comparative Example 3: Production of LED device 17)

LED device 17 was produced in the same manner as Example 10 except that tetramethoxysilane was not added, and methyltrimethoxysilane was added in the amount of 29.4 g and dimethoxydimethylsilane was added in the amount of 26.0 g.

(Example 15: Production of LED device 18)

LED device 18 was produced in the same manner as Example 10 except that methyltrimethoxysilane was not added and tetramethoxysilane was added in the amount of 65.9 g.
Evaluation results for the LED devices according to Examples 10 to 15 and Comparative Examples 2 and 3 were as shown in Table 14.

[Table 14]

| | LED device | Primer layer Kind of organic metal monomer/Reactive functional group | Light transmissive layer Silane compound polymerization ratio | Evaluation Adhesion | Erosion resistance | Crack resistance |
|---|---|---|---|---|---|---|
| Example 10 | 11 | | Trifunctional: tetrafunctional=2:8 | B | C | C |
| Example 11 | 12 | | Trifunctional: tetrafunctional=3:7 | B | B | B |
| Example 12 | 13 | | Trifunctional: tetrafunctional=5:5 | B | B | B |
| Example 13 | 14 | Zr alkoxide/ tetrafunctional | Trifunctional: tetrafunctional=7:3 | B | B | B |
| Example 14 | 15 | | Trifunctional: tetrafunctional=8:2 | C | B | B |
| Comparative Example 2 | 16 | | Only trifucntional | D | D | B |
| Comparative Example 3 | 17 | | Bifunctional: trifunctional=5:5 | D | D | B |
| Example 15 | 18 | | Only tetrafunctional | A | C | C |

As shown in Table 14 above, in the case where polysiloxane formed by polymerization of monomers including a tetrafunctional silane compound was added to the composition for light transmissive layer (Examples 11 to 15), adhesion between the LED element and the light transmissive layer was improved. Further, particularly, in the case where polysiloxane formed by polymerization of a tetrafunctional silane compound and a trifunctional silane compound at a polymerization molar ratio of 3:7 to 7:3 was added (Examples 11 to 13), erosion resistance or crack resistance was very excellent. On the other hand, when a polymerization molar ratio of the tetrafunctional silane compound was greater than the above-described range, during formation of the light transmissive layer, the light transmissive layer was greatly contracted and was likely to be partially cracked (Examples 10 and 15). When the polymerization molar ratio of the tetrafunctional silane compound was smaller than the lower limit of the above-described range, adhesion between the light transmissive layer and the wavelength conversion layer was likely to decrease (Example 14).

In the case where polysiloxane formed by polymerization of monomers including a bifunctional silane compound and a trifunctional silane compound without a tetrafunctional silane compound, or polysiloxane formed by polymerization of monomers including a trifunctional silane compound only was added, adhesion between the LED element and the light transmissive layer was decreased (Comparative Examples 2 and 3). It is assumed that this is because the amount of organic groups remaining in the polysiloxane was increased, and, thus, the polysiloxane and a metal of the organic metal monomer in the primer layer could not form a metal-oxane bonding sufficiently.

(Example 16: Production of LED device 19)

LED device 19 was produced in the same manner as Example 11 except that pure water was added to a composition for light transmissive layer in the amount of 3 wt% with respect to the total amount of the composition for light transmissive layer.

(Example 17: Production of LED device 20)

LED device 20 was produced in the same manner as Example 11 except that pure water was added to a composition for light transmissive layer in the amount of 10 wt% with respect to the total amount of the composition for light transmissive layer.

(Example 18: Production of LED device 21)

LED device 21 was produced in the same manner as Example 11 except that pure water was added to a composition for light transmissive layer in the amount of 15 wt% with respect to the total amount of the composition for light transmissive layer.

(Example 19: Production of LED device 22)

LED device 22 was produced in the same manner as Example 11 except that pure water was added to a composition for light transmissive layer in the amount of 25 wt% with respect to the total amount of the composition for light transmissive layer.

Evaluation results for the LED devices according to Examples 11 and 16 to 19 were as shown in Table 15.

[Table 15]

| | LED device | Primer layer | Light transmissive layer | | Evaluation | |
|---|---|---|---|---|---|---|
| | | Kind of organic metal monomer/Reactive functional group | Silane compound polymerization ratio | Water addition amount [wt %] | Moist-heat resistance | Pot life |
| Example 11 | 12 | Zr alkoxide/tetrafunctional | Trifunctional: tetrafunctional=3:7 | 0 | C | B |
| Example 16 | 19 | | | 3 | B | B |
| Example 17 | 20 | | | 10 | B | B |
| Example 18 | 21 | | | 15 | B | B |
| Example 19 | 22 | | | 25 | B | C |

As shown in Table 15, in the case where water was contained in the amount of 3 to 25 wt% in the composition for light transmissive layer, polysiloxane underwent a hydrolysis reaction before being condensed and a dense film was formed. Thus, a good moist-heat resistance was obtained (Examples 16 to 19) as compared with the case where water was not added (Example 11). On the other hand, in the case where water was contained in the amount of 25 wt% in the composition for light transmissive layer, a hydrolysis reaction caused by water was rapidly carried out and a storage property was decreased (Example 16).

(Example 20: Production of LED device 23)

LED device 23 was produced in the same manner as Example 17 except that a $ZrO_2$ dispersion liquid (produced by (Sakai Chemical Industry Co., Ltd.) in which zirconium oxide ($ZrO_2$) fine particles were dispersed was added to a composition for light transmissive layer such that the amount of the zirconium oxide was 20 wt% with respect to the total amount of the solid content in the composition for light transmissive layer.

Evaluation results for the LED devices according to Examples 17 and 20 were as shown in Table 16.

[Table 16]

| | LED device | Primer layer | Light transmissive layer | | | Evaluation | |
|---|---|---|---|---|---|---|---|
| | | Kind of organic metal monomer/Reactive functional group | Silane compound polymerization ratio | Water addition amount | Metal oxide fine particle | Erosion resistance | Crack resistance |
| Example 20 | 23 | Zr alkoxide/tetrafunctional | Trifunctional: tetrafunctional=3:7 | 10 | $ZrO_2$ | A | A |
| Example 17 | 20 | | | | - | B | B |

EP 2 800 154 A1

As shown in Table 16 above, in the case of adding the metal oxide fine particles to the light transmissive layer (Example 20), erosion resistance and crack resistance were improved. It is assumed that this is because a stress generated during formation of the light transmissive layer was relieved by the metal oxide fine particles and the light transmissive layer was not cracked.

Industrial Applicability

A sealing film for LED element formed of a sealant for an LED device of the present invention is excellent in sulfide gas resistance, heat resistance, and light resistance. Therefore, the present invention is suitable for use as a sealing film for an LED element in semiconductor LED devices such as lighting devices.

Reference Signs List

1:      Package
2:      Metal part
3:      LED chip
4:      Bump electrode or metal interconnection
5:      Primer layer
6:      Sealing layer
7:      Light transmissive layer
8:      Wavelength conversion layer
100:    LED device

**Claims**

1. A sealant for an LED device comprising:

    100 parts by weight of polysiloxane that has a weight-average molecular weight of 1,000 to 3,000 and is formed by polymerization of a trifunctional monomethylsilane compound and a tetrafunctional silane compound;
    5 to 100 parts by weight of an organic metal compound that is formed of a metal alkoxide or a metal chelate containing Group 4 or Group 13 metal elements; and
    a solvent.

2. The sealant for an LED device according to claim 1, wherein the polysiloxane is a polymer formed by polymerization of the trifunctional monomethylsilane compound and the tetrafunctional silane compound at a molar ratio of 3:7 to 7:3.

3. The sealant for an LED device according to claim 1, wherein the organic metal compound contains Zr.

4. The sealant for an LED device according to claim 1, wherein water is contained as the solvent; and the amount of the water added is 10 to 120 parts by weight with respect to 100 parts by weight of the polysiloxane.

5. The sealant for an LED device according to claim 1, further comprising inorganic fine particles.

6. The sealant for an LED device according to claim 1, wherein a pH is in a range of 1 to 4.

7. The sealant for an LED device according to claim 1, further comprising phosphor particles.

8. An LED device comprising:

    an LED element that emits a light having a specific wavelength; and
    a sealing layer formed of a cured film of the sealant for an LED device according to claim 1.

9. The LED device according to claim 8, further comprising on the sealing layer a wavelength conversion layer that contains a resin and phosphor particles and converts a light having a specific wavelength emitted from the LED element to a light having another specific wavelength.

**10.** A method for producing an LED device comprising:

applying the sealant for an LED device according to any one of claims 1 to 7 on an LED element; and
forming a sealing layer by curing the sealant at 100°C or higher.

**11.** An LED device comprising:

an LED element that emits a light having a specific wavelength;
a light transmissive layer that coats the LED element; and
a wavelength conversion layer that is disposed to be in contact with the light transmissive layer and configured to convert the light having a specific wavelength from the LED element into a light having another specific wavelength, wherein
the light transmissive layer is formed of a cured film made of a composition for light transmissive layer containing polysiloxane formed by polymerization of monomers including a tetrafunctional silane compound, metal oxide fine particles, and a solvent.

**12.** The LED device according to claim 11, wherein the metal oxide fine particles are an oxide of one or two or more metal elements selected from the group consisting of zirconium, titanium, tin, cerium, tantalum, niobium, and zinc.

**13.** The LED device according to claim 11, wherein the metal oxide fine particles has a concentration of 10 wt% to 60 wt% with respect to the solid content of the composition for light transmissive layer.

**14.** The LED device according to claim 11, wherein the metal oxide fine particles have an average primary particle size of 5 nm to 100 nm.

**15.** The LED device according to claim 11, wherein the polysiloxane is a polymer of monomers including a trifunctional monomethylsilane compound and a tetrafunctional silane compound, and the trifunctional monomethylsilane compound and the tetrafunctional silane compound are polymerized at a molar ratio of 3:7 to 7:3.

**16.** The LED device according to claim 11, wherein the composition for light transmissive layer contains an organic metal compound formed of a metal alkoxide or a metal chelate containing a metal element except element Si.

**17.** The LED device according to claim 11, wherein the composition for light transmissive layer includes water as the solvent; and the amount of the water added is 3 wt% to 15 wt% with respect to the total amount of the composition for light transmissive layer.

**18.** The LED device according to claim 11, wherein the light transmissive layer has a thickness of 0.5 to 10 $\mu$m.

**19.** A method for producing an LED device including: an LED element that emits a light having a specific wavelength; a light transmissive layer that coats the LED element; and a wavelength conversion layer that is disposed to be in contact with the light transmissive layer and configured to convert the light having a specific wavelength from the LED element into a light having another specific wavelength, the method comprising:

forming a light transmissive layer by applying and curing a composition for light transmissive layer containing polysiloxane formed by polymerization of monomers including a tetrafunctional silane compound, metal oxide fine particles, and a solvent.

**20.** An LED device comprising:

an LED element that emits a light having a specific wavelength;
a primer layer that coats the LED element;
a light transmissive layer that is disposed to be in contact with the primer layer; and
a wavelength conversion layer that is disposed on the light transmissive layer and configured to convert the light having a specific wavelength from the LED element into a light having another specific wavelength, wherein,
the primer layer is formed by applying and drying a composition for primer layer containing an organic metal monomer having a reactive functional group and a solvent on the LED element; and
the light transmissive layer is formed by applying and calcining a composition for light transmissive layer containing polysiloxane formed by polymerization of monomers including a tetrafunctional silane compound and a solvent on the primer layer.

21. The LED device according to claim 20, wherein the organic metal monomer is a monomer including any one or two or more metal elements of silicon, titanium, or zirconium.

22. The LED device according to claim 20, wherein the number of the reactive functional groups in the organic metal monomer is 3 or 4.

23. The LED device according to claim 20, wherein a surface of the primer layer contains 10 at.% to 35 at.% of a metal element derived from the organic metal monomer with respect to all elements present in the surface.

24. The LED device according to claim 20, wherein the polysiloxane is a polymer of monomers including a trifunctional monomethylsilane compound and a tetrafunctional silane compound, and the trifunctional monomethylsilane compound and the tetrafunctional silane compound are polymerized at a molar ratio of 3:7 to 7:3.

25. The LED device according to claim 20, wherein the composition for light transmissive layer includes water as the solvent, and the amount of the water added is 3 to 15 wt% with respect to the total amount of the composition for light transmissive layer.

26. The LED device according to claim 20, wherein the composition for light transmissive layer contains metal oxide fine particles.

27. The LED device according to claim 20, wherein the light transmissive layer has a thickness of 0.5 to 10 $\mu$m.

28. The LED device according to claim 20, wherein the wavelength conversion layer is a layer in which phosphor particles are dispersed in a transparent resin.

29. A method for producing an LED device including: an LED element that emits a light having a specific wavelength; a primer layer that coats the LED element; a light transmissive layer that is disposed to be in contact with the primer layer; and a wavelength conversion layer that is disposed on the light transmissive layer and configured to convert the light having a specific wavelength from the LED element into a light having another specific wavelength, the method comprising:

forming the primer layer by applying and drying a composition for primer layer containing an organic metal monomer having a reactive functional group and a solvent on the LED element; and
forming the light transmissive layer by applying and calcining a composition for light transmissive layer containing polysiloxane formed by polymerization of monomers including a tetrafunctional silane compound and a solvent on the primer layer.

FIG. 1

FIG. 2

FIG. 3

FIG. 4

FIG. 5

FIG. 6

FIG. 7

| | **INTERNATIONAL SEARCH REPORT** | International application No. |
|---|---|---|
| | | PCT/JP2012/008216 |

**A. CLASSIFICATION OF SUBJECT MATTER**
*H01L33/56*(2010.01)i

According to International Patent Classification (IPC) or to both national classification and IPC

**B. FIELDS SEARCHED**

Minimum documentation searched (classification system followed by classification symbols)
H01L33/00-33/64, C08G77/00-77/62

Documentation searched other than minimum documentation to the extent that such documents are included in the fields searched
Jitsuyo Shinan Koho           1922-1996   Jitsuyo Shinan Toroku Koho   1996-2013
Kokai Jitsuyo Shinan Koho   1971-2013   Toroku Jitsuyo Shinan Koho   1994-2013

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2008-115332 A (Mitsubishi Chemical Corp.), 22 May 2008 (22.05.2008), paragraphs [0041] to [0061], [0068], [0074] to [0089]; fig. 1 (Family: none) | 1-10 |
| Y | WO 2010/150861 A1 (Asahi Kasei E-materials Corp.), 29 December 2010 (29.12.2010), paragraphs [0022] to [0032], [0114], [0131] to [0151], [0166] to [0169] & US 2012/100298 A1      & EP 2447303 A1 & CN 102459423 A         & KR 10-2012-0022878 A | 1-10 |

☐  Further documents are listed in the continuation of Box C.        ☐  See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 11 March, 2013 (11.03.13) | 19 March, 2013 (19.03.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

<table>
<tr><td>**INTERNATIONAL SEARCH REPORT**</td><td>International application No.<br>PCT/JP2012/008216</td></tr>
</table>

**Box No. II      Observations where certain claims were found unsearchable (Continuation of item 2 of first sheet)**

This international search report has not been established in respect of certain claims under Article 17(2)(a) for the following reasons:

1. ☐ Claims Nos.:
     because they relate to subject matter not required to be searched by this Authority, namely:

2. ☐ Claims Nos.:
     because they relate to parts of the international application that do not comply with the prescribed requirements to such an extent that no meaningful international search can be carried out, specifically:

3. ☐ Claims Nos.:
     because they are dependent claims and are not drafted in accordance with the second and third sentences of Rule 6.4(a).

**Box No. III      Observations where unity of invention is lacking (Continuation of item 3 of first sheet)**

This International Searching Authority found multiple inventions in this international application, as follows:
     The invention of claim 1, the invention of claim 11 and the invention of claim 19 respectively have no same or corresponding special technical feature.
     Accordingly, the following three inventions (invention groups) are involved in claims.

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☒ No required additional search fees were timely paid by the applicant. Consequently, this international search report is restricted to the invention first mentioned in the claims; it is covered by claims Nos.:
     1-10

**Remark on Protest**      ☐ The additional search fees were accompanied by the applicant's protest and, where applicable, the payment of a protest fee.

     ☐ The additional search fees were accompanied by the applicant's protest but the applicable protest fee was not paid within the time limit specified in the invitation.

     ☐ No protest accompanied the payment of additional search fees.

Form PCT/ISA/210 (continuation of first sheet (2)) (July 2009)

(Invention 1) the inventions of claims 1-10
   A sealing agent for LED devices, which contains 100 parts by mass of a polysiloxane that is obtained by polymerizing a trifunctional monomethylsilane compound and a tetrafunctional silane compound and has a mass average molecular weight of 1,000-3,000, 5-100 parts by mass of an organic metal compound that is composed of a metal alkoxide or metal chelate containing a group 4 or group 13 metal element, and a solvent; an LED device which comprises a sealing layer that is formed from the sealing agent for LED devices; or a method for manufacturing the LED device.
   (Invention 2) the inventions of claims 11-18
   An LED device, which comprises an LED element that emits light having a specific wavelength, a light transmitting layer that covers the LED element, and a wavelength conversion layer that is arranged so as to be in contact with the light transmitting layer and converts the light from the LED element having a specific wavelength to light having another specific wavelength, and wherein the light transmitting layer is formed of a cured film of a composition for light transmitting layers, said composition containing a polysiloxane that is obtained by polymerizing a monomer containing a tetrafunctional silane compound, fine metal oxide particles and a solvent; and a method for manufacturing the LED device.
   (Invention 3) the inventions of claims 19-29
   An LED device, which comprises an LED element that emits light having a specific wavelength, a primer layer that covers the LED element, a light transmitting layer that is arranged so as to be in contact with the primer layer, and a wavelength conversion layer that is arranged on the light transmitting layer and converts the light from the LED element having a specific wavelength to light having another specific wavelength, and wherein the primer layer is formed by applying a composition for primer layers, which contains an organic metal monomer having a reactive functional group and a solvent, over the LED element and drying the composition thereon, and the light transmitting layer is formed by applying a composition for light transmitting layers, which contains a polysiloxane obtained by polymerizing a monomer containing a tetrafunctional silane compound and a solvent, over the primer layer and firing the composition thereon; or a method for manufacturing the LED device.

Form PCT/ISA/210 (extra sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002314142 A
- JP 2011166148 A
- JP 2007324256 A
- JP 3275308 B
- JP 2003197976 A

- JP 2004231947 A
- JP 2002033517 A
- JP 2002203989 A
- JP 2002076445 A
- JP 2010182970 A

**Non-patent literature cited in the description**

- Technology of Optimal Use of Coupling Agen. National Institute of Advanced Science and Technology